# EUROPEAN PATENT APPLICATION

(11) **EP 4 797 910 A1**
(43) Date of publication of application: **26.08.2026**
(21) Application number: 24879392.9
(22) Date of filing: 18.07.2024
(51) Int. Cl.: H10F 39/12, H04N 25/70

(54) **LIGHT DETECTION DEVICE**

(30) Priority: 20.10.2023 JP 2023180783
(71) Applicant: Sony Semiconductor Solutions Corporation, Atsugi-shi, Kanagawa 243-0014 (JP)
(72) Inventor: TOMITA, Ken, Atsugi-shi, Kanagawa 2430014 (JP); ONO, Shun, Atsugi-shi, Kanagawa 2430014 (JP); NISHIKAWA, Takashi, Tokyo 1700013 (JP)
(74) Representative: MFG Patentanwälte Meyer-Wildhagen Meggle-Freund Gerhard PartG mbB
(86) International application number: PCT/JP2024/025799
(87) International publication number: WO 2025/083961

(57) **Abstract**

The present technology relates to a light detection device that can increase a saturation charge amount and improve transfer efficiency. The light detection device includes a photoelectric conversion section that is formed in a semiconductor substrate and converts light into charge, an accumulation section that temporarily accumulates the charge, a transfer section that transfers the charge to the accumulation section, an assist section that assists at least one or both of the transfer by the transfer section and an increase in a saturation charge amount, a first electrode included in the transfer section and located on a front surface of the semiconductor substrate, and a second electrode included in the assist section and located in the semiconductor substrate. The present technology is applicable to, for example, an imaging device.

## Description

### Technical Field

The present technology relates to a light detection device, and for example, relates to a light detection device that increases a saturation charge amount.

### Background Art

In general, an imaging device such as a complementary metal oxide semiconductor (CMOS) image sensor or a charge coupled device (CCD) is widely used in a digital still camera, a digital video camera, or the like. For example, incident light incident on a CMOS image sensor is photoelectrically converted by a photodiode (PD) included in a pixel. Then, the charge generated in the PD is transferred to a floating diffusion (FD) via a transfer transistor, converted into a pixel signal of a level corresponding to the amount of received light in the FD, and read out.

As a means for improving the saturation charge amount of the imaging element, PTL 1 proposes reading out the charge from the PD using a vertical gate.

### Citation List

### Patent Literature

PTL 1: JP 2010-114273 A

### Summary

### Technical Problem

It is desired to improve the light detection characteristics such as reducing the amount of charge remaining after transfer when transferring the charge from the PD and increasing the saturation charge amount.

The present technology has been made in view of such circumstances, and an object thereof is to improve the light detection characteristics.

### Solution to Problem

A first light detection device according to an aspect of the present technology includes a photoelectric conversion section formed in a semiconductor substrate and configured to convert light into charge, an accumulation section configured to temporarily accumulate the charge, a transfer section configured to perform transfer of the charge to the accumulation section, an assist section configured to assist at least one or both of the transfer by the transfer section and an increase in a saturation charge amount, a first electrode included in the transfer section and located on a front surface of the semiconductor substrate, and a second electrode included in the assist section and located in the semiconductor substrate.

A second light detection device according to an aspect of the present technology includes a photoelectric conversion section formed in a semiconductor substrate and configured to convert light into charge, an accumulation section configured to temporarily accumulate the charge, a first transfer section configured to perform transfer of the charge to the accumulation section, and a second transfer section, in which in a depth direction of the semiconductor substrate with a front surface of the semiconductor substrate as a reference, a first electrode included in the first transfer section is provided from a first position as the reference to a second position, a second electrode included in the second transfer section is provided from the first position to a third position deeper than the second position, the first electrode includes two electrodes disposed at positions facing each other, the two electrodes forming a pair, and the second electrode includes two electrodes disposed at positions facing each other, the two electrodes forming a pair.

The first light detection device according to the aspect of the present technology includes a photoelectric conversion section formed in a semiconductor substrate and configured to convert light into charge, an accumulation section configured to temporarily accumulate the charge, a transfer section configured to perform transfer of the charge to the accumulation section, and an assist section configured to assist at least one or both of the transfer by the transfer section and an increase in a saturation charge amount. A first electrode included in the transfer section is provided on a front surface of the semiconductor substrate, and a second electrode included in the assist section is provided in the semiconductor substrate.

In the second light detection device according to the aspect of the present technology, a photoelectric conversion section formed in a semiconductor substrate and configured to convert light into charge, an accumulation section configured to temporarily accumulate the charge, a first transfer section configured to perform transfer of the charges to the accumulation section, and a second transfer section are provided, in a depth direction of the semiconductor substrate with a front surface of the semiconductor substrate as a reference, a first electrode included in the first transfer section is provided from a first position as the reference to a second position, a second electrode included in the second transfer section is provided from the first position to a third position deeper than the second position, the first electrode includes two electrodes disposed at positions facing each other, the two electrodes forming a pair, and the second electrode includes two electrodes disposed at positions facing each other, the two electrodes forming a pair.

Note that the light detection device may be an independent device or may be an internal block constituting one device.

### Brief Description of Drawings

[Fig. 1]

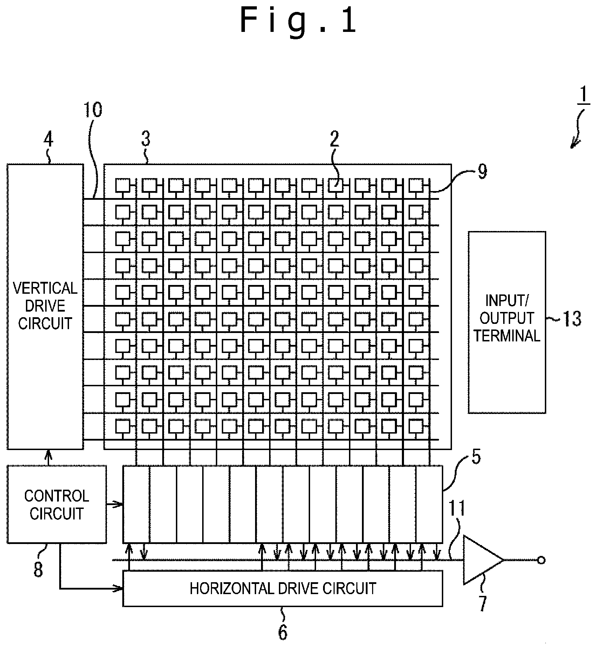

   Fig. 1 is a diagram depicting a configuration example of an embodiment of an imaging device to which the present technology is applied.
[Fig. 2]

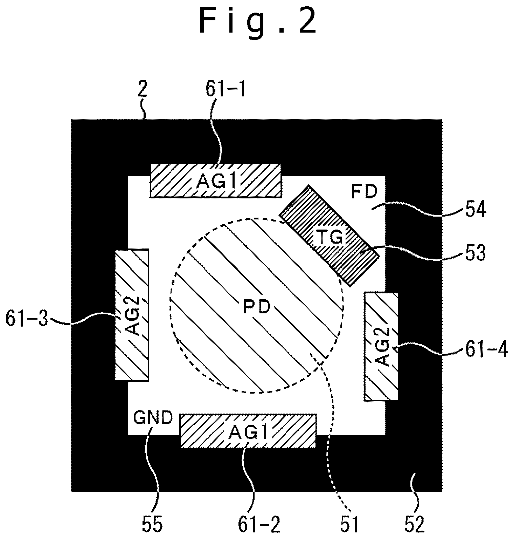

   Fig. 2 is a diagram depicting a planar configuration example of a pixel.
[Fig. 3]

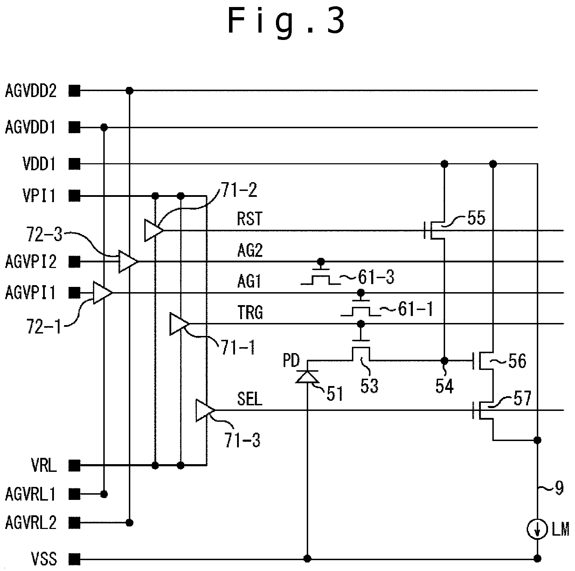

   Fig. 3 is a diagram depicting a circuit configuration example of a pixel.
[Fig. 4]

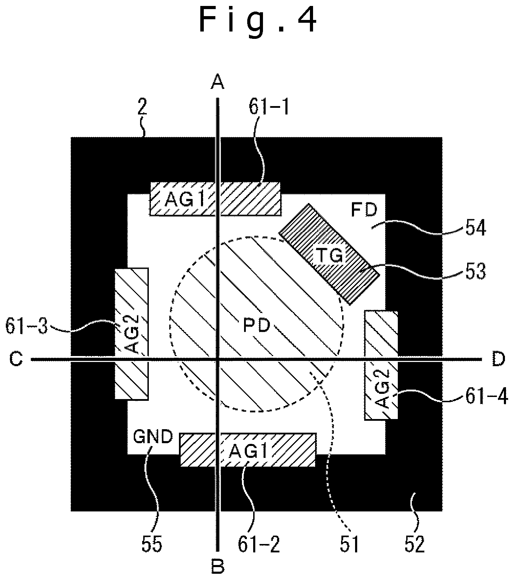

   Fig. 4 is a diagram depicting a planar configuration example of a pixel according to a first embodiment.
[Fig. 5]

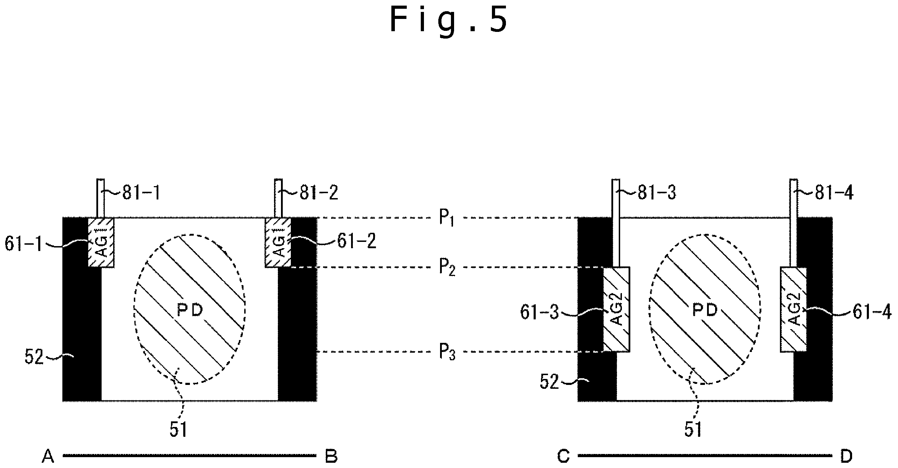

   Fig. 5 is a diagram depicting a cross-sectional configuration example of the pixel according to the first embodiment.
[Fig. 6]

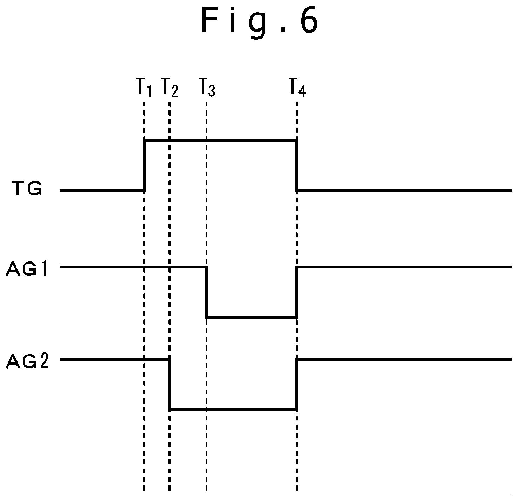

   Fig. 6 is a timing chart for explaining an operation at the time of reading out a pixel.
[Fig. 7]

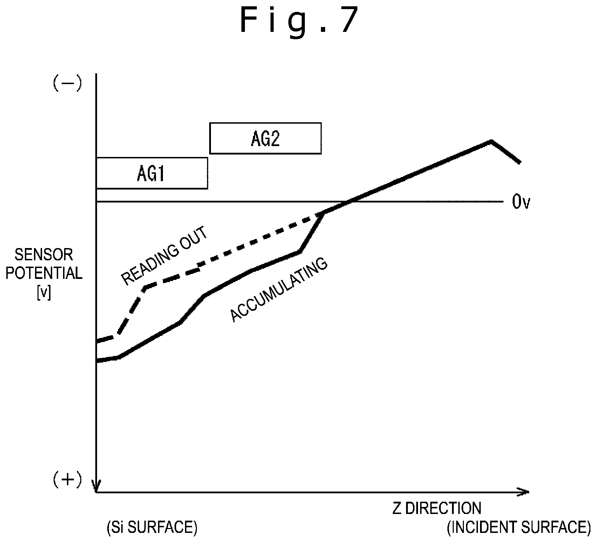

   Fig. 7 is a diagram for explaining a change in a sensor potential.
[Fig. 8]

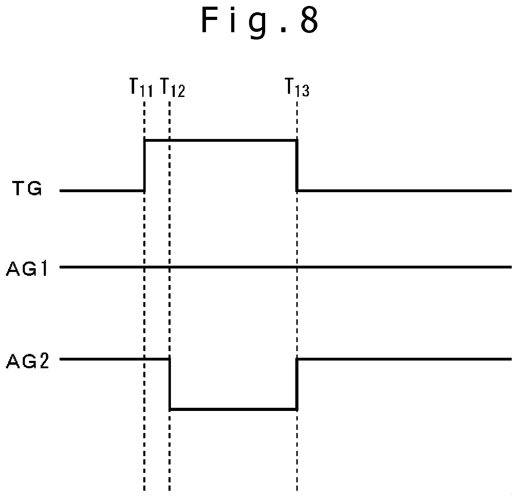

   Fig. 8 is a timing chart for explaining an operation at the time of reading out a pixel.
[Fig. 9]

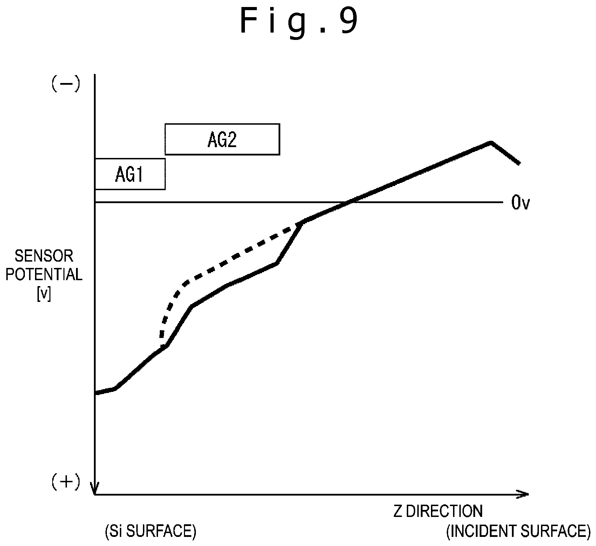

   Fig. 9 is a diagram for explaining a change in the sensor potential.
[Fig. 10]

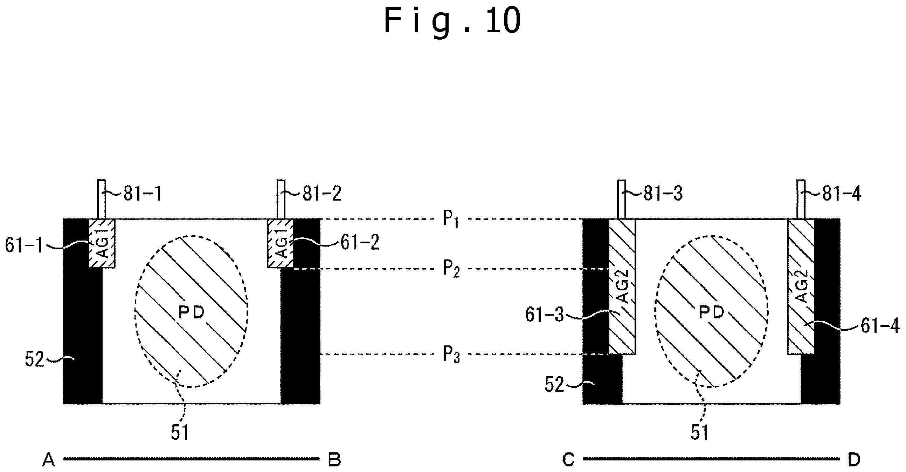

   Fig. 10 is a diagram depicting a cross-sectional configuration example of a pixel according to a second embodiment.
[Fig. 11]

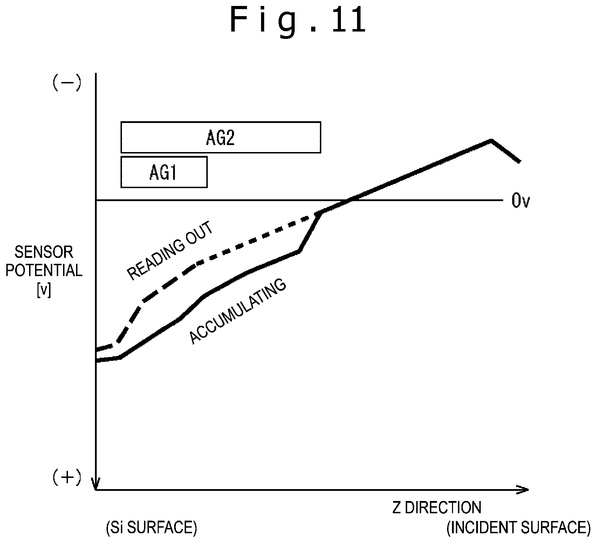

   Fig. 11 is a diagram for explaining a change in a sensor potential.
[Fig. 12]

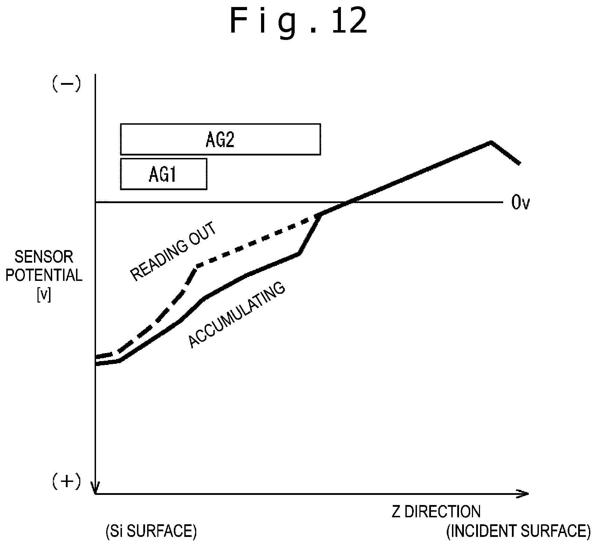

   Fig. 12 is a diagram for explaining a change in the sensor potential.
[Fig. 13]

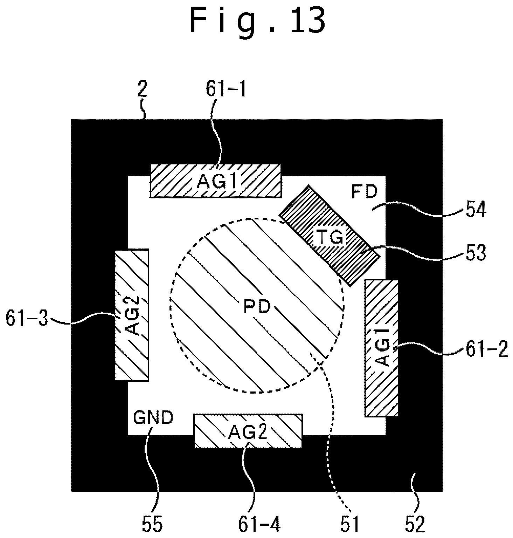

   Fig. 13 is a diagram depicting a planar configuration example of a pixel according to a third embodiment.
[Fig. 14]

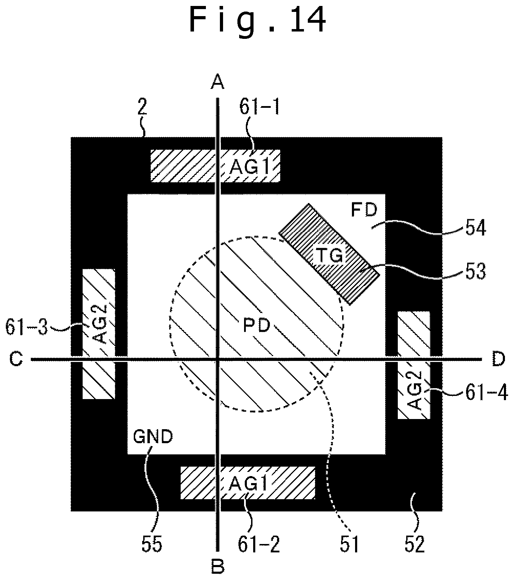

   Fig. 14 is a diagram depicting a planar configuration example of a pixel according to a fourth embodiment.
[Fig. 15]

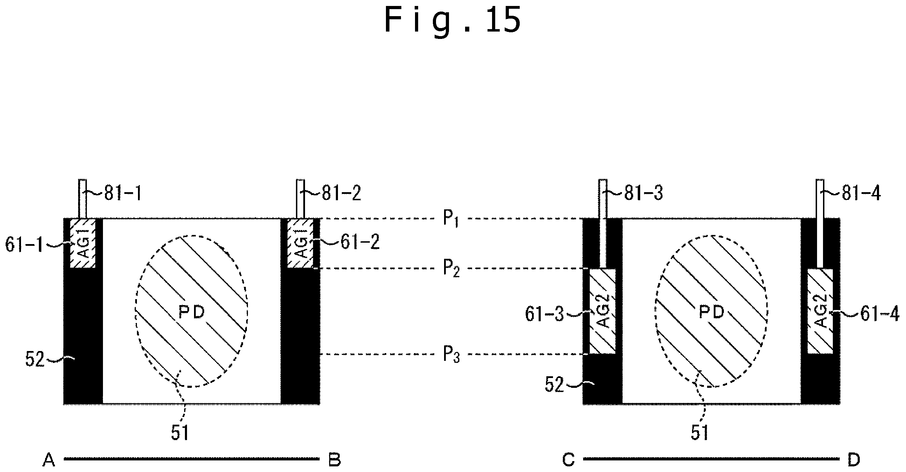

   Fig. 15 is a diagram depicting a cross-sectional configuration example of the pixel according to the fourth embodiment.
[Fig. 16]

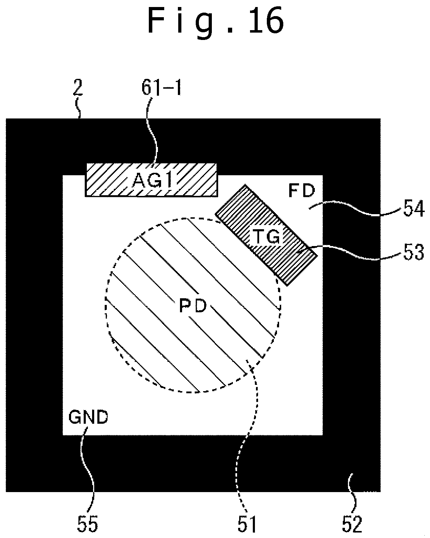

   Fig. 16 is a diagram for explaining the arrangement of a gate electrode AG.
[Fig. 17]

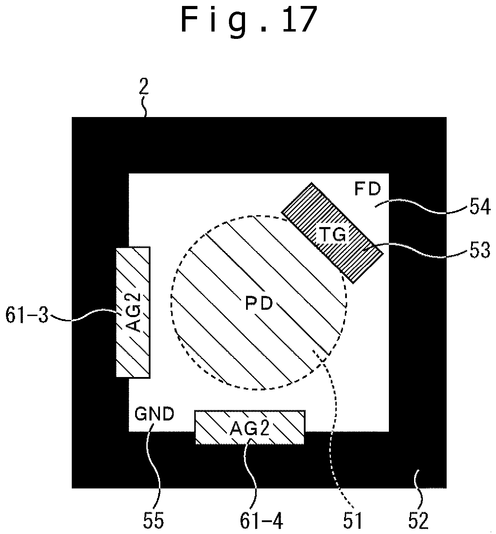

   Fig. 17 is a diagram for explaining the arrangement of a gate electrode AG.
[Fig. 18]

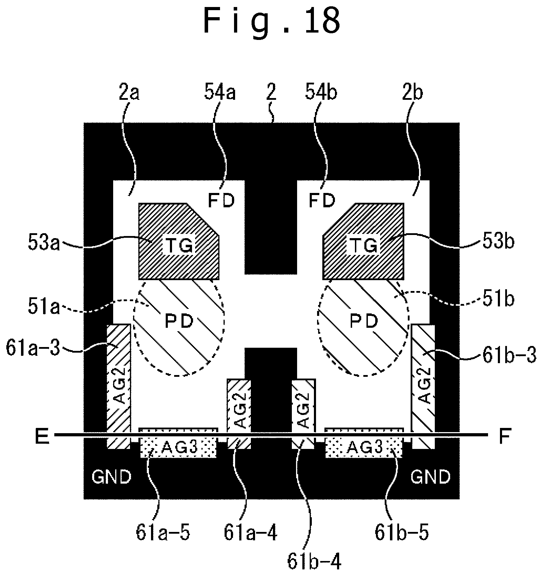

   Fig. 18 is a diagram depicting a planar configuration example of a pixel according to a fifth embodiment.
[Fig. 19]

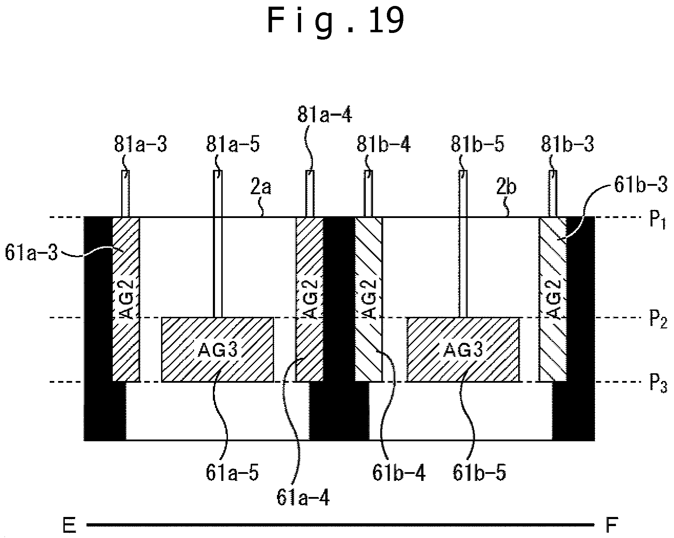

   Fig. 19 is a diagram depicting a cross-sectional configuration example of the pixel according to the fifth embodiment.
[Fig. 20]

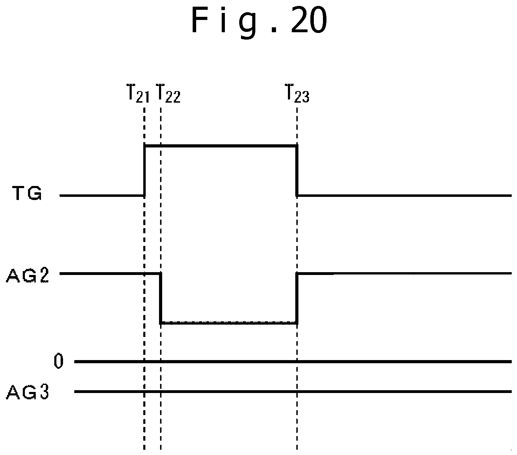

   Fig. 20 is a timing chart for explaining an operation at the time of reading out a pixel.
[Fig. 21]

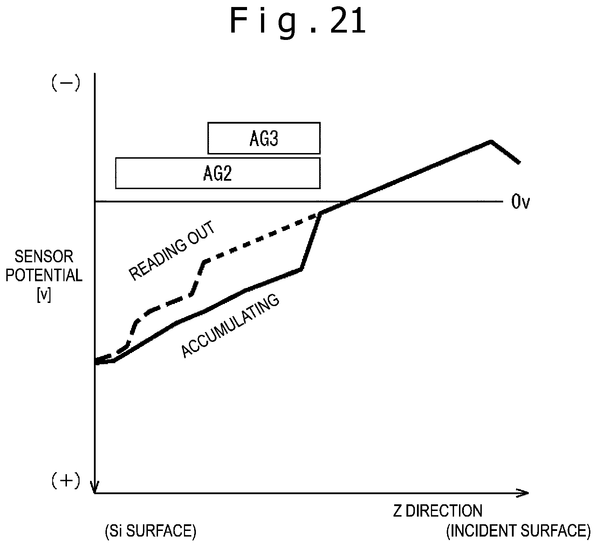

   Fig. 21 is a diagram for explaining a change in a sensor potential.
[Fig. 22]

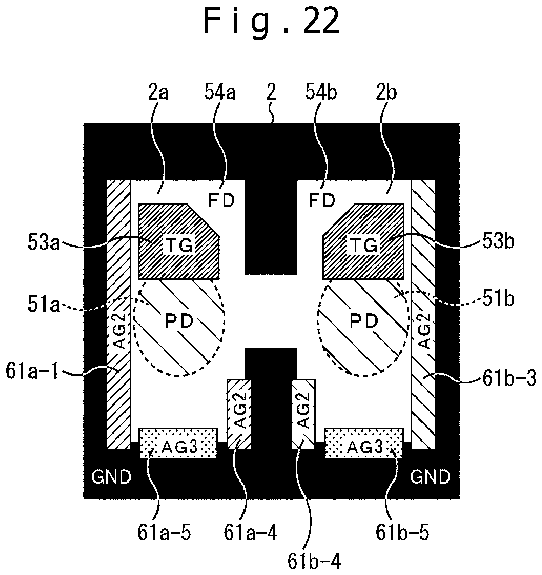

   Fig. 22 is a diagram depicting another planar configuration example of the pixel according to the fifth embodiment.
[Fig. 23]

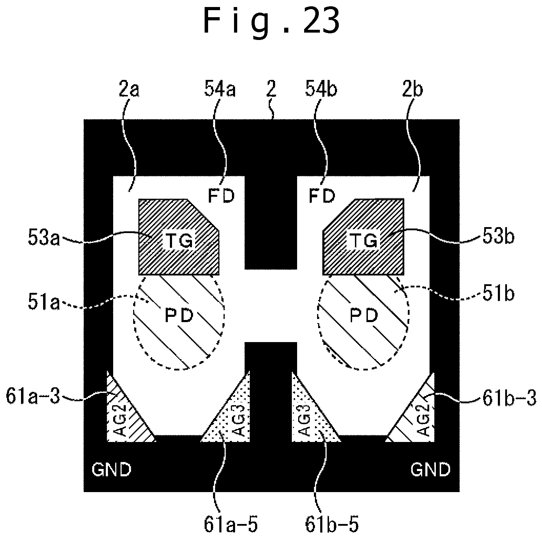

   Fig. 23 is a diagram depicting still another planar configuration example of the pixel according to the fifth embodiment.
[Fig. 24]

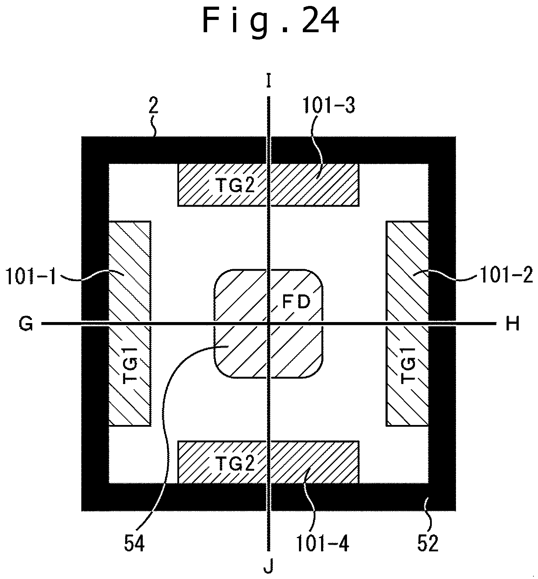

   Fig. 24 is a diagram depicting a planar configuration example of a pixel according to a sixth embodiment.
[Fig. 25]

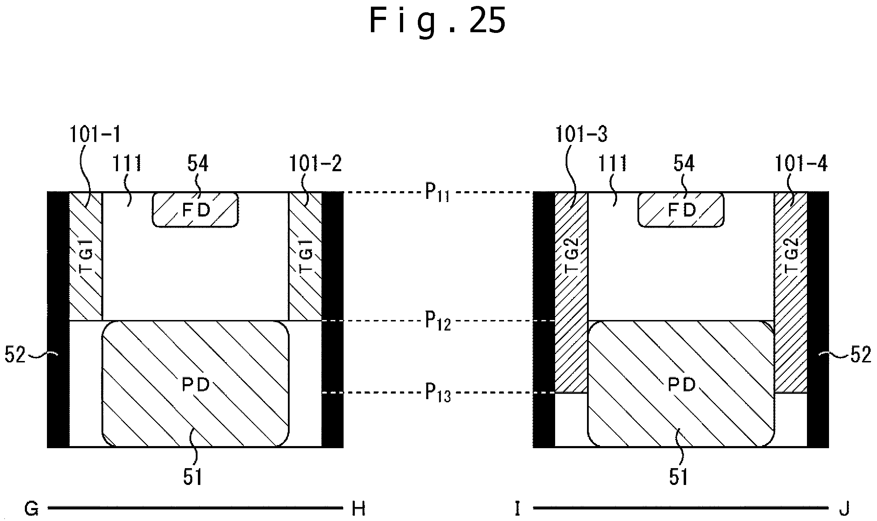

   Fig. 25 is a diagram depicting a cross-sectional configuration example of the pixel according to the sixth embodiment.
[Fig. 26]

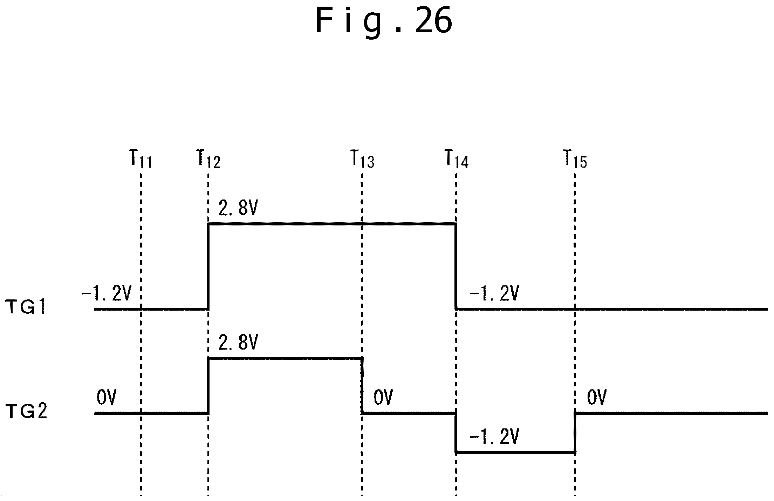

   Fig. 26 is a timing chart for explaining an operation at the time of reading out a pixel.
[Fig. 27]

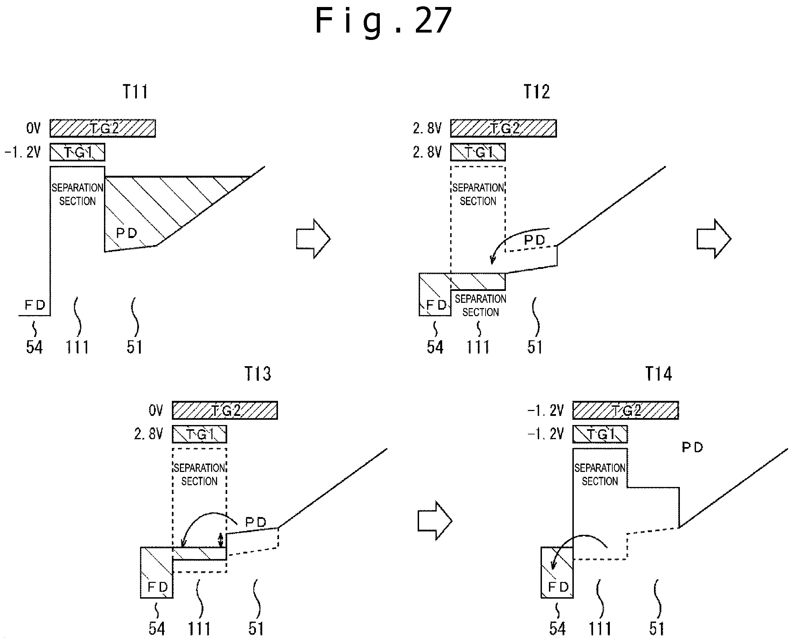

   Fig. 27 is a diagram for explaining a change in a sensor potential.
[Fig. 28]

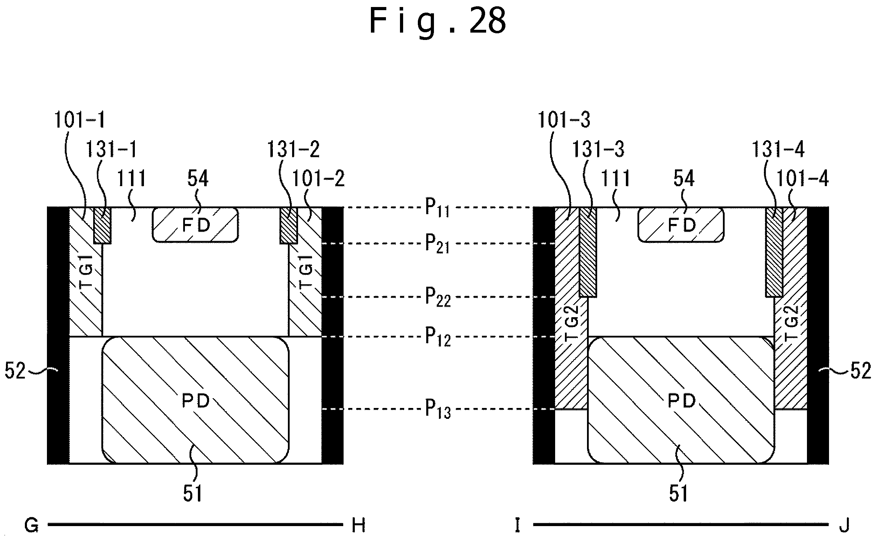

   Fig. 28 is a diagram depicting a cross-sectional configuration example of a pixel according to a seventh embodiment.
[Fig. 29]

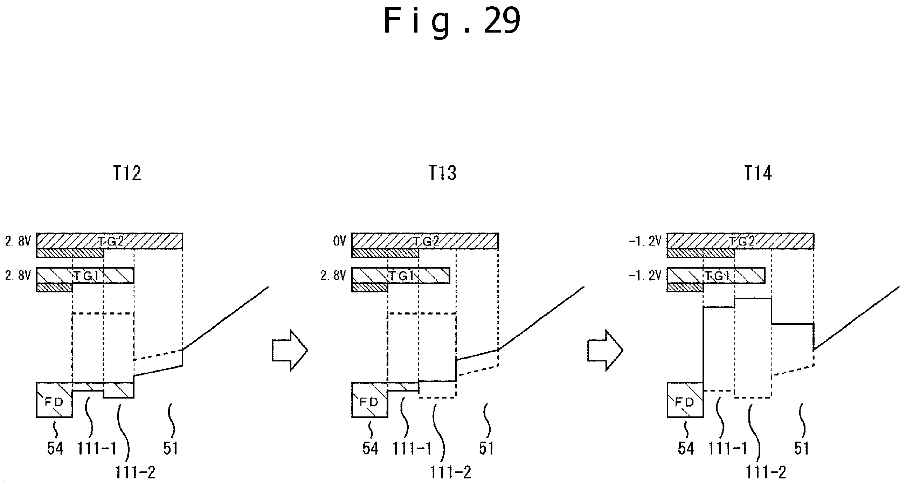

   Fig. 29 is a diagram for explaining a change in a sensor potential.
[Fig. 30]

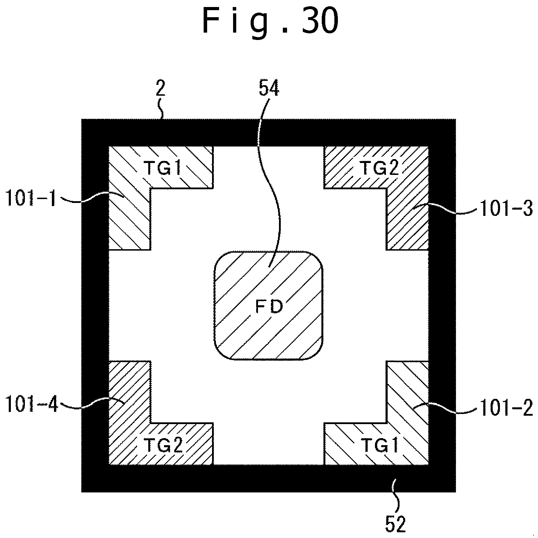

   Fig. 30 is a diagram depicting a planar configuration example of a pixel according to an (8-1)-th embodiment.
[Fig. 31]

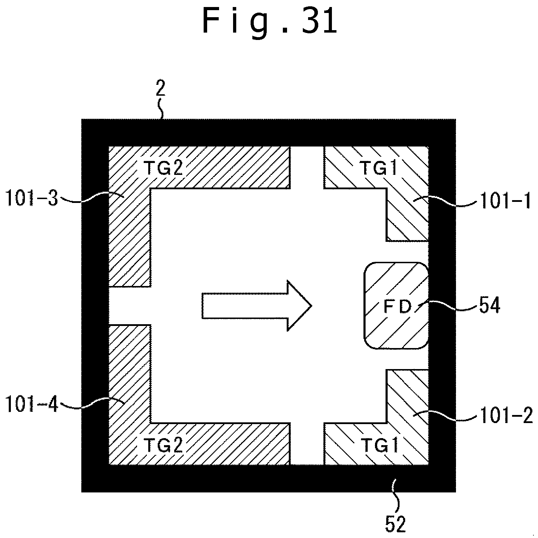

   Fig. 31 is a diagram depicting a planar configuration example of a pixel according to an (8-2)-th embodiment.
[Fig. 32]

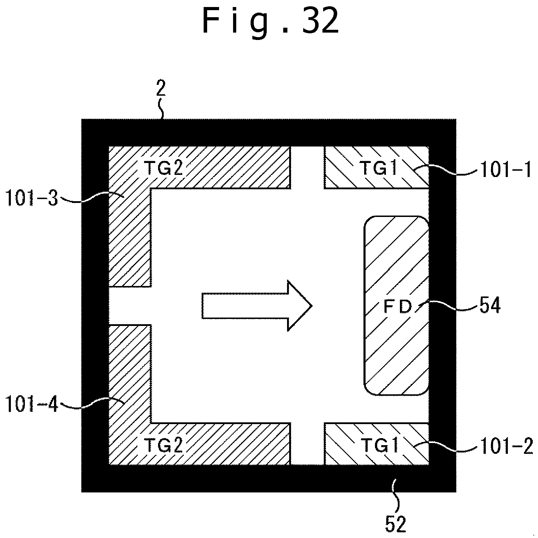

   Fig. 32 is a diagram depicting a planar configuration example of a pixel according to an (8-3)-th embodiment.
[Fig. 33]

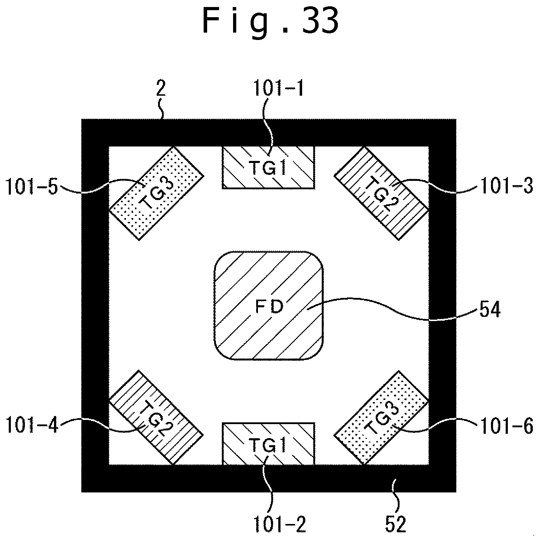

   Fig. 33 is a diagram depicting a planar configuration example of a pixel according to a (9-1)-th embodiment.
[Fig. 34]

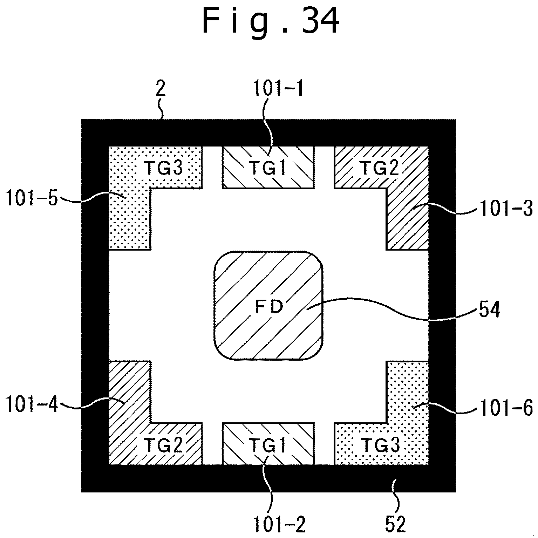

   Fig. 34 is a diagram depicting a planar configuration example of a pixel according to a (9-2)-th embodiment.
[Fig. 35]

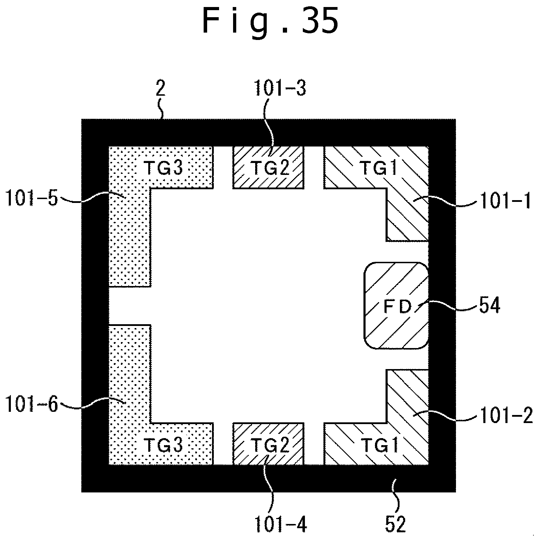

   Fig. 35 is a diagram depicting a planar configuration example of a pixel according to a (9-3)-th embodiment.
[Fig. 36]

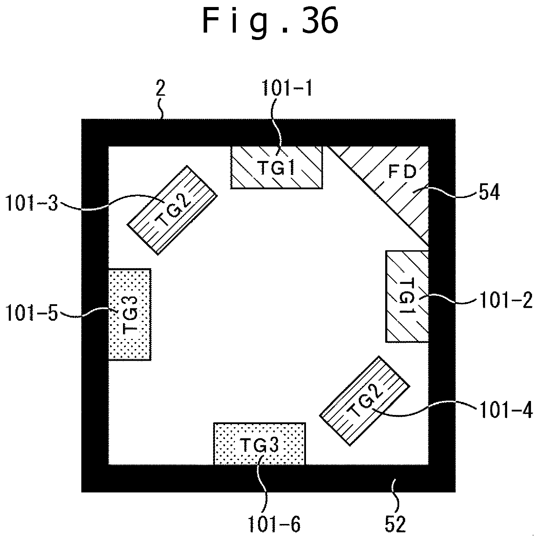

   Fig. 36 is a diagram depicting a planar configuration example of a pixel according to a (9-4)-th embodiment.
[Fig. 37]

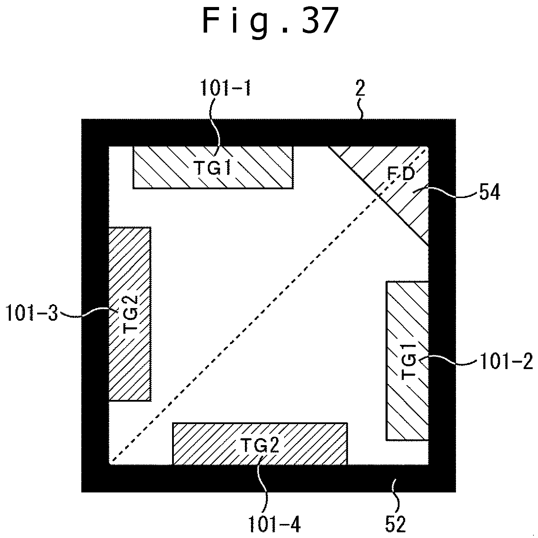

   Fig. 37 is a diagram depicting a planar configuration example of a pixel according to a (10-1)-th embodiment.
[Fig. 38]

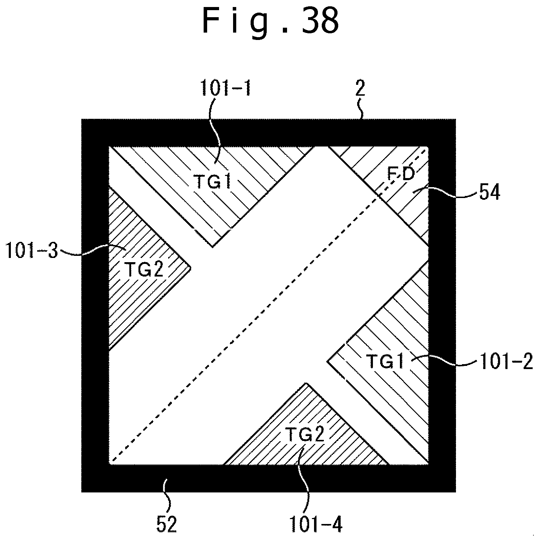

   Fig. 38 is a diagram depicting a planar configuration example of a pixel according to a (10-2)-th embodiment.
[Fig. 39]

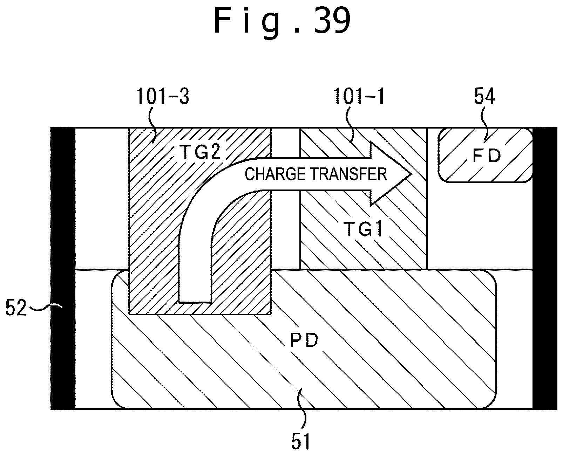

   Fig. 39 is a diagram for explaining charge transfer of a pixel according to a tenth embodiment.
[Fig. 40]

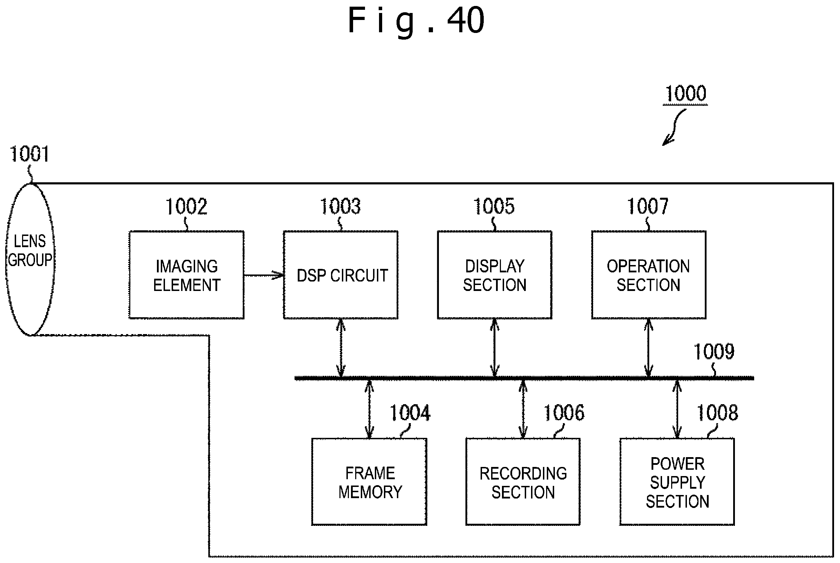

   Fig. 40 is a diagram depicting a configuration example of an electronic apparatus.
[Fig. 41]

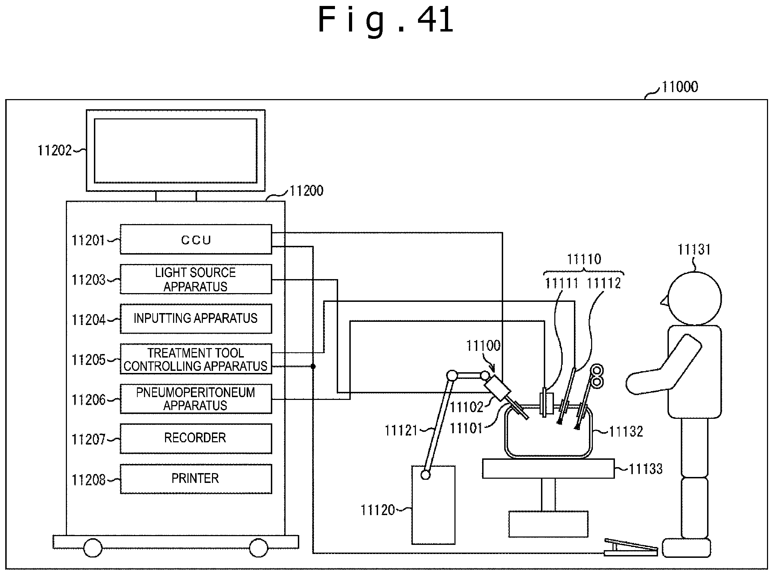

   Fig. 41 is a diagram depicting an example of schematic configuration of an endoscopic surgery system.
[Fig. 42]

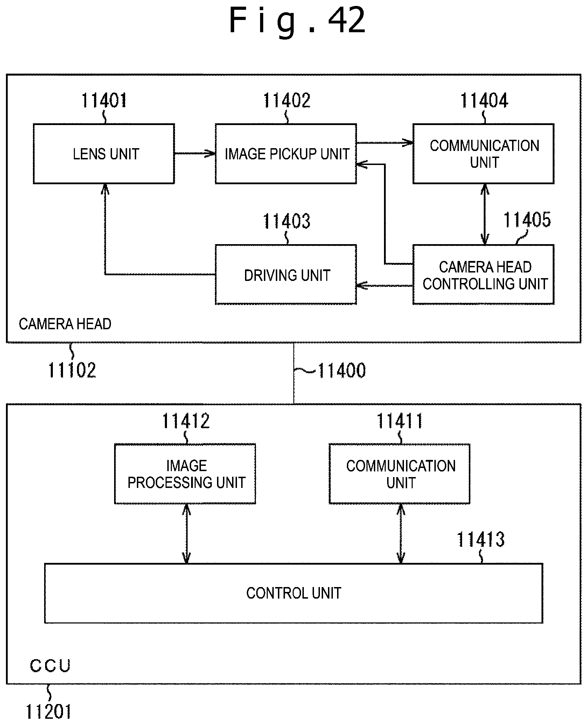

   Fig. 42 is a block diagram depicting an example of a functional configuration of a camera head and a CCU.
[Fig. 43]

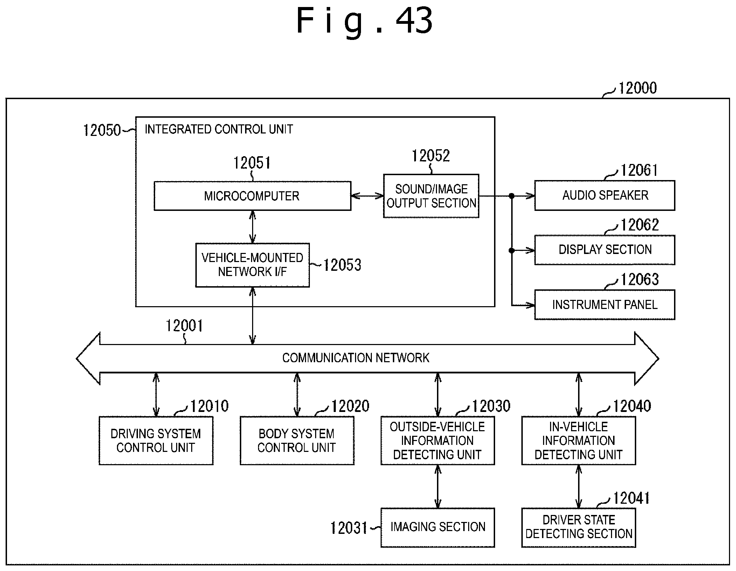

   Fig. 43 is a block diagram depicting an example of a schematic configuration of a vehicle control system.
[Fig. 44]

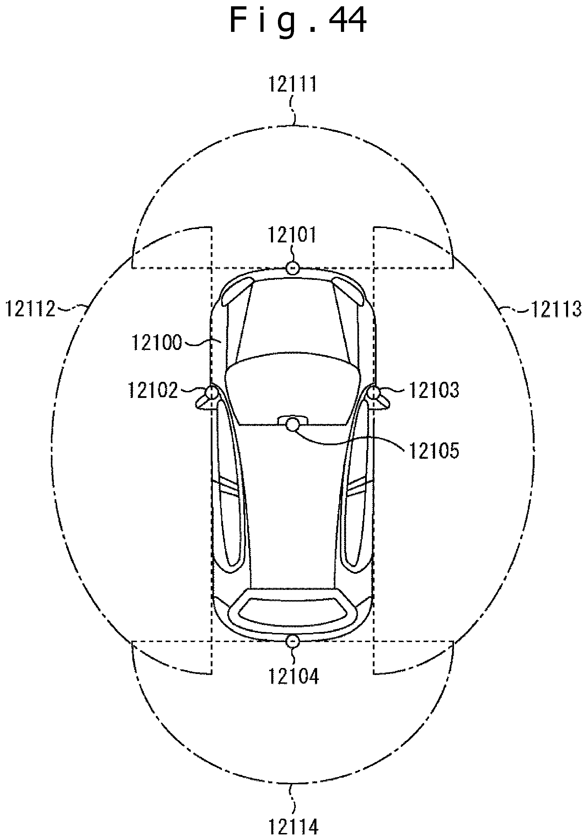

   Fig. 44 is a diagram depicting an example of installation positions of an outside-vehicle information detecting section and an imaging section.

### Description of Embodiments

Hereinafter, aspects for carrying out the present technology (hereinafter, embodiments) will be described.

### Configuration Example of Imaging Device

Since a light detection device to which the present technology is applied can be applied to, for example, an imaging device, the imaging device will be described here as an example. Fig. 1 depicts a configuration example according to an embodiment of an imaging device to which the present technology is applied.

An imaging device 1 in Fig. 1 is configured to include a pixel array section 3 in which pixels 2 are arrayed in a two-dimensional array, and a peripheral circuit section around the pixel array section 3. The peripheral circuit section includes a vertical drive circuit 4, a column signal processing circuit 5, a horizontal drive circuit 6, an output circuit 7, a control circuit 8, and the like.

The pixel 2 includes a photodiode as a photoelectric conversion element and a plurality of pixel transistors. The plurality of pixel transistors are, for example, a transfer transistor, a selection transistor, a reset transistor, an amplification transistor, and the like, and are constituted of MOS transistors.

The control circuit 8 receives an input clock and data for providing instructions related to an operation mode and the like, and outputs data such as internal information of the imaging device 1. That is, the control circuit 8 generates a clock signal and a control signal that are references of operations of the vertical drive circuit 4, the column signal processing circuit 5, the horizontal drive circuit 6, and the like, on the basis of a vertical synchronization signal, a horizontal synchronization signal, and a master clock. The control circuit 8 outputs the generated clock signal and control signal to the vertical drive circuit 4, the column signal processing circuit 5, the horizontal drive circuit 6, and the like.

The vertical drive circuit 4 is constituted of, for example, a shift register, selects a predetermined pixel drive line 10, supplies a pulse for driving the pixels 2 to the selected pixel drive line 10, and drives the pixels 2 in units of rows. That is, the vertical drive circuit 4 sequentially and selectively scans the pixels 2 of the pixel array section 3 in a vertical direction in units of rows to cause the pixels 2 to supply a pixel signal based on a signal charge generated in accordance with an amount of received light in a photoelectric conversion section of each pixel 2 to the column signal processing circuit 5 through a vertical signal line 9.

The column signal processing circuit 5 is disposed for each column of the pixels 2, and performs signal processing such as noise removal on the signals output from the pixels 2 of one row for each pixel column. For example, the column signal processing circuit 5 performs signal processing such as correlated double sampling (CDS) or double data sampling (DDS) for removing fixed pattern noise unique to the pixel and analog-to-digital (AD) conversion.

The horizontal drive circuit 6 is constituted of, for example, a shift register, and sequentially selects each of the column signal processing circuits 5 by sequentially outputting a horizontal scanning pulse, and causes each of the column signal processing circuits 5 to output a pixel signal to a horizontal signal line 11.

The output circuit 7 performs signal processing on the signals sequentially supplied from the respective column signal processing circuits 5 through the horizontal signal line 11 and outputs the processed signals. The output circuit 7 may, for example, perform only buffering, or may perform black level adjustment, column variation correction, various digital signal processing, and the like. An input/output terminal 13 exchanges signals with the outside.

The imaging device 1 configured as described above is a CMOS image sensor called a column AD type in which the column signal processing circuit 5 that performs the CDS processing or the DDS processing and the AD conversion processing is disposed for each pixel column.

### Configuration Example of Pixel

Fig. 2 is a diagram depicting a planar configuration example of an embodiment of the pixel 2 to which the present technology is applied. A detailed configuration of the pixel 2 will be described below with reference to Fig. 4 and subsequent drawings, and first, the configuration of the pixel 2 will be briefly described with reference to Fig. 2.

In Fig. 2 and the following description, a left-right direction in the figure is defined as an X-axis direction, and an up-down direction in the figure is defined as a Y-axis direction. The description will be continued assuming that an X direction in Fig. 2 corresponds to a row direction (horizontal direction) in Fig. 1, and a Y direction corresponds to a column direction (vertical direction) in Fig. 1.

As illustrated in Fig. 2, a photodiode (PD) 51 is provided in a region of a central portion of the rectangular pixel 2. For example, the PD 51 is formed in units of pixels 2 by forming an N-type (second conductivity type) semiconductor region in units of pixels 2 in a P-type (first conductivity type) semiconductor region in a semiconductor substrate 50 made of silicon (Si). The PD 51 and the adjacent PD 51 are separated by an inter-pixel separation section 52. The PD 51 is surrounded by the inter-pixel separation section 52.

A gate electrode TG of a transfer transistor 53 is provided on the upper left side of the PD 51 in the figure. The transfer transistor 53 transfers the charge accumulated in the PD 51 to a floating diffusion (FD) 54. The FD 54 is provided at the upper right corner in the figure. A GND 55 to which a reference potential is supplied is provided on the lower left side in the figure. The pixel 2 is configured to have a potential gradient from the GND 55 toward the gate electrode TG in plan view.

A gate electrode AG of an assist transistor 61 that assists the transfer of the charge by the transfer transistor 53 is provided on a side surface of the inter-pixel separation section 52. The inter-pixel separation section 52 located on the upper side in the figure is provided with a gate electrode AG1 of an assist transistor 61-1. The inter-pixel separation section 52 located on the lower side in the figure is provided with the gate electrode AG1 of an assist transistor 61-2.

The inter-pixel separation section 52 located on the left side in the figure is provided with a gate electrode AG2 of an assist transistor 61-3. The inter-pixel separation section 52 located on the right side in the figure is provided with the gate electrode AG2 of an assist transistor 61-4. Note that in the following description, when it is not necessary to distinguish the assist transistors 61-1 to 61-4 from each other, the assist transistors 61-1 to 61-4 are simply referred to as the assist transistor 61. The other parts are described in the same manner.

When the charge is read out from the PD 51, the transfer transistor 53 and the assist transistor 61 are turned on, supply a predetermined voltage, and modulate the potential in the pixel 2. The transfer transistor 53 and the assist transistor 61 are connected to different power supply circuits and supply different voltages, respectively. This will be described with reference to the circuit diagram of Fig. 3.

### Circuit Configuration of Pixel 2

Fig. 3 is a diagram depicting a circuit configuration example of the pixel 2. The PD 51 generates and accumulates charge (signal charge) corresponding to the amount of received light. The anode terminal of the PD 51 is connected to a wiring line (Vss wiring line) connected to the GND or a negative power supply, and a cathode terminal is connected to the FD 54 via the transfer transistor 53.

When the transfer transistor 53 is turned on by a transfer signal TRG, the transfer transistor 53 reads out the charge generated in the PD 51 and transfers the charge to the FD 54. The transfer signal TRG is supplied from a driver 71-1. The driver 71-1 is connected to a power supply node VPI1 and a power supply node VRL, and operates based on the power supply voltage VPI1 and the power supply voltage VRL.

The FD 54 holds the charge read from the PD 51. When the reset transistor 55 is turned on by a reset signal RST, the charge accumulated in the FD 54 is discharged to a drain (constant voltage supply Vdd), and thus the reset transistor 55 resets the potential of the FD 54. The reset signal RST is supplied from the driver 71-1. The driver 71-1 is connected to the power supply node VPI1 and the power supply node VRL, and operates based on the power supply voltage VPI1 and the power supply voltage VRL.

An amplification transistor 56 outputs a pixel signal corresponding to the potential of the FD 54. That is, the amplification transistor 56 constitutes a source follower circuit with a constant current supply LM connected via the vertical signal line 9, and the pixel signal indicating a level corresponding to the charge accumulated in the FD 54 is output from the amplification transistor 56 to the column signal processing circuit 5 (Fig. 1) via a selection transistor 57 and the vertical signal line 9.

The selection transistor 57 is turned on when the pixel 2 is selected by a selection signal SEL, and outputs the pixel signal of the pixel 2 to the column signal processing circuit 5 via the vertical signal line 9. The selection signal SEL is supplied from a driver 71-3. The driver 71-3 is connected to the power supply node VPI1 and the power supply node VRL, and operates based on the power supply voltage VPI1 and the power supply voltage VRL. Each signal line through which a transfer signal TR, the selection signal SEL, and the reset signal RST are transmitted corresponds to the pixel drive line 10 in Fig. 1.

A circuit for controlling the assist transistor 61 is provided separately from these circuits. In Fig. 3, the assist transistor 61-1 and the assist transistor 61-3 will be described as an example.

When the assist transistor 61-1 is turned on by the assist signal AG1, a predetermined voltage is applied to the assist transistor 61-1, and the assist transistor 61-1 modulates a sensor potential in the pixel 2. The assist signal AG1 is supplied from a driver 72-1. The driver 72-1 is connected to a power supply node AGVDD1 and a power supply node AGVRL1, and operates based on the power supply voltage AGVDD1 and the power supply voltage AGVRL1, and based on a control signal AGVPI1 from the control unit (or the vertical drive circuit 4 (Fig. 1)) which is not illustrated. The assist transistor 61-2, which is not illustrated in Fig. 3, is also connected to the driver 72-1 and is controlled by the same driving as the assist transistor 61-1.

When the assist transistor 61-3 is turned on by the assist signal AG2, a predetermined voltage is applied to the assist transistor 61-3, and the assist transistor 61-3 modulates the sensor potential in the pixel 2. The assist signal AG2 is supplied from a driver 72-3. The driver 72-3 is connected to a power supply node AGVDD2 and a power supply node AGVRL2, and operates based on the power supply voltage AGVDD2 and the power supply voltage AGVRL2, and based on a control signal AGVPI2 from the control unit (or the vertical drive circuit 4 (Fig. 1)) which is not illustrated. The assist transistor 61-4, which is not illustrated in Fig. 3 is also connected to the driver 72-3 and is controlled by the same driving as the assist transistor 61-3.

The pixel 2 can be configured as described above, but is not limited to this configuration, and other configurations can also be adopted.

### First Embodiment

The configuration of the pixel 2 according to the first embodiment will be described with reference to Figs. 4 and 5. Fig. 4 is a diagram in which a line segment A-B and a line segment C-D are added to the planar configuration example of the pixel 2 illustrated in Fig. 2. Fig. 5 is a diagram depicting a cross-sectional configuration example of the pixel 2 taken along the line segment A-B in Fig. 4 and a cross-sectional configuration example of the pixel 2 taken along the line segment C-D in Fig. 4.

The line segment A-B is a line segment passing through the assist transistor 61-1 and the assist transistor 61-2, and the cross-sectional configuration of the pixel 2 taken along the line segment A-B is as illustrated in the left diagram of Fig. 5. The PD 51 is formed in a central portion of the semiconductor substrate 50 of the pixel 2, and the inter-pixel separation section 52 is provided so as to surround the PD 51.

The inter-pixel separation section 52 is formed by, for example, front full trench isolation (FFTI) that penetrates the semiconductor substrate 50. The inter-pixel separation section 52 can be formed as a trench that does not penetrate or penetrates the semiconductor substrate. The pixels 2 are separated from each other by an insulator by the inter-pixel separation section 52, and the pixels 2 are electrically separated from each other. A configuration in which pixels are separated by ion implantation can be applied to the inter-pixel separation section 52.

Here, a back-illuminated imaging element will be described as an example. In the case of the back-illuminated type, the lower side in the figure is an incident surface on which light is incident, and is a surface on which a color filter, an on-chip lens, and the like (not illustrated) are laminated. The upper side in the figure is a surface on the opposite side of the light incident surface, and is a surface on which wiring layers (not illustrated) in which a transistor and the like are formed are laminated. Hereinafter, the lower surface in the figure is referred to as a light incident surface or a back surface, and the upper surface in the figure is referred to as a surface on the wiring layer side or a front surface.

Note that the present technology can also be applied to a front-illuminated imaging device, and the application range is not limited to the back-illuminated imaging device.

Reference will be made to the left diagram of Fig. 5. The position of the front surface is defined as a position P1. The gate electrode AG1 of the assist transistor 61-1 is formed along the side surface of the inter-pixel separation section 52 from the position P1 of the front surface to the position of a position P2 in a depth direction. The gate electrode AG1 of the assist transistor 61-2 is formed along the side surface of the inter-pixel separation section 52 from the position P1 of the front surface to the position of the position P2. The gate electrode AG1 of the assist transistor 61-1 and the gate electrode AG1 of the assist transistor 61-2 are formed to the same depth in the depth direction.

Referring to Fig. 4, the gate electrode AG1 of the assist transistor 61-1 and the gate electrode AG1 of the assist transistor 61-2 are gate electrodes arranged at positions facing each other. A pair of gate electrodes AG1 arranged at the positions facing each other are formed to the same depth in the depth direction.

In the example illustrated in Fig. 4, in the horizontal direction (X-axis direction), the gate electrode AG1 of the assist transistor 61-1 disposed on the side closer to the gate electrode TG of the transfer transistor 53 is formed longer than the gate electrode AG1 of the assist transistor 61-2 disposed on the side farther from the gate electrode TG of the transfer transistor 53. In the horizontal direction, the size is set as appropriate in relation to the gate electrode TG. For example, the gate electrode AG1 in the horizontal direction is formed as long as possible without being in contact with the gate electrode TG and without being in contact with the sides perpendicularly intersecting the side, on which the gate electrode AG1 is provided, of the inter-pixel separation sections 52.

Reference will be made to the right diagram in Fig. 5. The gate electrode AG2 of the assist transistor 61-3 is formed along the side surface of the inter-pixel separation section 52 from the position P2 to the position of a position P3 in the depth direction. The gate electrode AG2 of the assist transistor 61-4 is formed along the side surface of the inter-pixel separation section 52 from the position P2 to the position of the position P3 in the depth direction. The gate electrode AG2 of the assist transistor 61-3 and the gate electrode AG2 of the assist transistor 61-4 are formed to the same depth in the depth direction.

Referring to Fig. 4, the gate electrode AG2 of the assist transistor 61-3 and the gate electrode AG2 of the assist transistor 61-4 are gate electrodes arranged at positions facing each other. A pair of gate electrodes AG2 arranged at the positions facing each other are formed to the same depth in the depth direction.

In the example illustrated in Fig. 4, in the vertical direction (Y-axis direction), the gate electrode AG2 of the assist transistor 61-4 disposed on the side closer to the gate electrode TG of the transfer transistor 53 is formed longer than the gate electrode AG2 of the assist transistor 61-3 disposed on the side farther from the gate electrode TG of the transfer transistor 53. In the vertical direction, the size is set as appropriate in relation to the gate electrode TG. For example, the gate electrode AG2 in the vertical direction is formed as long as possible without being in contact with the gate electrode TG and without being in contact with the side perpendicularly intersecting the side, on which the gate electrode AG2 is provided, of the inter-pixel separation section 52.

When the gate electrodes AG1 of the assist transistors 61-1 and 61-2 and the gate electrodes AG2 of the assist transistors 61-3 and 61-4 are viewed, the gate electrodes AG1 and the gate electrodes AG2 are configured so as not to have portions overlapping in the depth direction. The gate electrode AG1 is formed from the position P1 to the position P2, and the gate electrode AG2 is formed from the position P2 to the position P3, so that there is no overlapping portion in the depth direction.

The gate electrode AG1 and the gate electrode AG2 are provided in different regions in the depth direction such that the region in which the sensor potential in the pixel 2 is modulated by the gate electrode AG1 and the region in which the sensor potential in the pixel 2 is modulated by the gate electrode AG2 are different from each other.

Here, the description will be continued with the assumption that the gate electrodes AG formed on the shallower side are the gate electrodes AG1 and the gate electrodes AG formed on the deeper side are the gate electrodes AG2, with reference to the front surface of the semiconductor substrate 50.

As a portion related to transfer of the charge from the PD 51 to the FD portion 54, the gate electrode TG of the transfer transistor 53 is provided on the front surface side of the semiconductor substrate 50, and the gate electrode AG of the assist transistor 61 is provided in the semiconductor substrate 50. The gate electrode AG of the assist transistor 61 includes the gate electrode AG1 and the gate electrode AG2 having different depths in the semiconductor substrate 50.

The gate electrode AG1 of the assist transistor 61-1 is connected to a wiring line 81-1, and the gate electrode AG1 of the assist transistor 61-2 is connected to a wiring line 81-2. The wiring line 81-1 and the wiring line 81-2 are wiring lines to which the assist signal AG1 is supplied. The gate electrode AG2 of the assist transistor 61-3 is connected to a wiring line 81-3, and the gate electrode AG2 of the assist transistor 61-4 is connected to a wiring line 81-4. The wiring line 81-3 and the wiring line 81-4 are wiring lines to which the assist signal AG2 is supplied.

The gate electrode TG of the transfer transistor 53 may be a plane electrode provided in a plane shape on the front surface (position P1) of the semiconductor substrate 50. The gate electrode TG of the transfer transistor 53 may be a vertical electrode in which an electrode provided in a plane shape on the front surface (position P1) of the semiconductor substrate 50 and an electrode provided vertically in the semiconductor substrate 50 are combined.

The gate electrode TG of the transfer transistor 53 may have a shape in which a plane electrode or a vertical electrode is divided into two or more. The gate electrode TG of the transfer transistor 53 is not limited to the shape described here, and other shapes can be applied to the present technology. That is, the configuration in which the assist transistor 61 is provided can be applied regardless of the shape of the gate electrode TG of the transfer transistor 53.

### Operation of Assist Transistor 61

An operation related to readout of the charge from the PD 51 of the pixel 2 including the assist transistor 61 will be described with reference to a timing chart of Fig. 6. Note that since the assist transistor 61-1 and the assist transistor 61-2 are driven in the same manner, the following description will be continued by taking the assist transistor 61-1 as an example. Further, since the assist transistor 61-3 and the assist transistor 61-4 are driven in the same manner, the following description will be continued by taking the assist transistor 61-3 as an example.

At a time T1 when the readout of the charge from the PD 51 is started, the transfer signal TRG is supplied to the transfer transistor 53, and the transfer transistor 53 is turned on. When the transfer transistor 53 is turned on, a predetermined positive voltage is applied to the transfer transistor 53.

At a time T2 when a predetermined time has elapsed from the time T1, the assist signal AG2 is supplied to the assist transistor 61-3, and the assist transistor 61-3 is turned on. When the assist transistor 61-3 is turned on, a predetermined negative voltage is applied to the assist transistor 61-3. When a predetermined negative voltage is applied to the assist transistor 61-3, the sensor potential in the semiconductor substrate 50 is modulated by the influence of the gate electrode AG2 provided in the semiconductor substrate 50.

At a time T3 when a predetermined time has elapsed from the time T2, the assist signal AG1 is supplied to the assist transistor 61-1, and the assist transistor 61-1 is turned on. When the assist transistor 61-1 is turned on, a predetermined negative voltage is applied to the assist transistor 61-1. When a predetermined negative voltage is applied to the assist transistor 61-1, the sensor potential in the semiconductor substrate 50 is modulated by the influence of the gate electrode AG1 provided in the semiconductor substrate 50.

At a time T4, when the readout of the charge from the PD 51 is ended, the transfer transistor 53, the assist transistor 61-1, and the assist transistor 61-3 each are returned to an off state.

In this manner, the assist transistor 61-3 (the gate electrode AG2) located at a deep position in the semiconductor substrate 50, in other words, located at a position away from the transfer transistor 53 in the depth direction is turned on before the assist transistor 61-1 (the gate electrode AG1) located at a shallow position, in other words, located at a position close to the transfer transistor 53 in the depth direction, and is controlled such that a predetermined voltage is applied thereto.

By turning on the assist transistor 61-3 provided at a position away from the transfer transistor 53, in other words, at a position close to the light incident surface, the accumulated charge can be moved from the deep position to the shallow position. By turning on the assist transistor 61-1 at the timing at which the charge is moved to the shallow position, the charge can be moved to a further shallow position, that is, the transfer transistor 53 side. By shifting the timing at which the assist transistor 61-1 is turned on and the timing at which the assist transistor 61-3 is turned on, a direction in which the charge easily flows can be created, and the transfer of the charge by the transfer transistor 53 can be more efficiently performed.

Note that, although the case where the assist transistor 61-1 and the assist transistor 61-3 are turned on at different timings has been described as an example, the assist transistors 61-1 and 61-3 may be turned on at the same time. Even in the case of being turned on at the same time, a direction in which the charge easily flows can be created, and the transfer of the charge by the transfer transistor 53 can be performed more efficiently.

The voltage applied to the gate electrode AG1 and the voltage applied to the gate electrode AG2 may be the same voltage, or either of the voltages may be set higher.

Here, the case where the voltage applied to the gate electrode TG of the transfer transistor 53 is a positive voltage and the voltage applied to the gate electrode AG of the assist transistor 61 is a negative voltage has been described as an example. In this manner, the voltages applied to the transfer transistor 53 and the assist transistor 61 are voltages having different phases. Note that, depending on the characteristics of the pixel 2 and the like, the voltages applied to the transfer transistor 53 and the assist transistor 61 can be changed as appropriate, such as voltages having the same phase, so that a desired operation is obtained.

Fig. 7 is a diagram for explaining a change in the sensor potential at the time of accumulation and at the time of readout. The horizontal axis of the graph illustrated in Fig. 7 represents a Z direction, the left side is the front surface (Si surface) side of the semiconductor substrate 50, and the right side is the light incident surface side. The vertical axis represents the sensor potential [v], and the lower side is a positive side and the upper side is a negative side. For reference, the positions where the gate electrode AG1 and the gate electrode AG2 are provided are illustrated on the upper side of the figure.

In the figure, the graph indicated by the solid line is a graph at the time of charge accumulation, and the graph indicated by the dotted line is a graph at the time of readout. During accumulation, both the transfer transistor 53 and the assist transistor 61 are in the off state, and during readout, both the transfer transistor 53 and the assist transistor 61 are in an on state. Since the negative voltage is applied by the assist transistor 61 at the time of readout, the graph at the time of readout is a graph modulated in a negative direction as compared with the graph at the time of accumulation.

The difference between the solid line graph and the dotted line graph corresponds to the difference in a saturation charge amount (Qs), and it can be read that the saturation charge amount can be increased by the modulation of the sensor potential by the assist transistor 61.

The gate electrode AG1 is provided at a position close to the surface on which the transfer transistor 53 is formed. By applying the negative voltage to the gate electrode AG1, the potential on the Si surface (front surface) side can be lowered. This enables transfer even when the bias of the transfer transistor 53 is lower than a predetermined value. Therefore, the voltage applied to the transfer transistor 53 can be reduced, and the power consumption can be reduced.

### Other Operations of Assist Transistor 61

Another operation related to readout of the charge from the PD 51 of the pixel 2 including the assist transistor 61 will be described with reference to a timing chart of Fig. 8. The timing chart illustrated in Fig. 8 illustrates the operation of driving only the assist transistors 61-3 and 61-4 of the gate electrode AG2 without driving the assist transistors 61-1 and 61-2 of the gate electrode AG1 among the assist transistors 61-1 to 61-4.

At a time T11 when the readout of the charge from the PD 51 is started, the transfer signal TRG is supplied to the transfer transistor 53, and the transfer transistor 53 is turned on. At a time T12 when a predetermined time has elapsed from the time T11, the assist signal AG2 is supplied to the assist transistor 61-3, and the assist transistor 61-3 is turned on. When the assist transistor 61-3 is turned on, a predetermined negative voltage is applied to the assist transistor 61-3, and the modulation of the sensor potential by the gate electrode AG2 is started.

At a time T13, when the readout of the charge from the PD 51 is ended, the transfer transistor 53 and the assist transistor 61-3 each are returned to the off state.

The assist transistor 61-1 is not turned on and is maintained in the off state even between the time t11 and the time T13. Therefore, the sensor potential is not modulated by the influence of the gate electrode AG1 of the assist transistor 61-1.

The change in the sensor potential when the operation illustrated in Fig. 8 is performed will be described with reference to Fig. 9. The graph illustrated in Fig. 9 is a graph showing the change in the sensor potential in the depth direction at the time of accumulation and at the time of readout, similarly to the graph illustrated in Fig. 7.

The graph at the time of accumulation indicated by the solid line is the same as the graph illustrated in Fig. 7. When only the gate electrode AG2 is driven and a predetermined voltage is applied at the time of readout, the sensor potential in the region where the gate electrode AG2 is present, in other words, a range affected by the voltage due to the gate electrode AG2, is as shown by the dotted line.

Since the sensor potential in the range affected by the voltage due to the gate electrode AG2 is modulated, the sensor potential changes steeply in a boundary region between the affected region and the unaffected region. In this case, the boundary is the position P2 (Fig. 5).

Since such a region where the sensor potential changes steeply can be created, the transfer gradient can be increased, the transfer remainder at the time of transfer can be reduced, and the transfer efficiency can be improved. Further, the saturation charge amount (Qs) can be increased by the difference between the solid line and the dotted line in the graph. In this manner, by adjusting the location and size of the assist transistor 61, the timing of applying a voltage, and the like, it is possible to improve the transfer efficiency and increase the saturation charge amount. The assist transistor 61 is configured to assist at least one of the transfer of the transfer transistor 53 and the increase in the saturation charge amount.

A mode in which the assist transistors 61-1 and 61-2 each having the gate electrode AG1 are driven is referred to as a drive mode, and a mode in which the assist transistors 61-1 and 61-2 each having the gate electrode AG1 are not driven is referred to as a non-drive mode.

For example, the drive mode or the non-drive mode can be set in accordance with the characteristics of the pixel 2. For example, when the characteristics of the pixel 2 are measured at the time of manufacture, and the saturation charge amount is greatly increased and the power consumption is also reduced according to the characteristics, the drive mode is set, and the setting information can be written in a register or the like. For example, the characteristics of the pixel 2 are measured at the time of manufacturing, and when the saturation charge amount does not need to be increased so much due to the characteristics, the non-drive mode can be set.

A mechanism may be provided in which the drive mode or the non-drive mode is set by a user after manufacturing, in other words, when being used by the user. In the case of the drive mode, the voltage applied to the transfer transistor 53 can be made lower than that in the non-drive mode, and power consumption can be reduced. For example, a mechanism may be provided in which the drive mode is presented to the user as a power consumption reduction mode, the non-drive mode is presented to the user as a normal mode, and the user can set either the power consumption reduction mode or the normal mode.

A mechanism may be provided in which the drive mode or the non-drive mode is set depending on an image to be picked up (an image being picked up).

### Second Embodiment

Fig. 10 is a diagram depicting a cross-sectional configuration example of the pixel 2 according to a second embodiment. Since the planar configuration example of the pixel 2 according to the second embodiment can be the planar configuration example illustrated in Fig. 4 described above, here, the description will be continued assuming that the planar configuration example of the pixel 2 in the second embodiment is the planar configuration example illustrated in Fig. 4.

Fig. 10 is a diagram depicting a cross-sectional configuration example of the pixel 2 taken along the line segment A-B in Fig. 4 and a cross-sectional configuration example of the pixel 2 taken along the line segment C-D in Fig. 4. The cross-sectional configuration example of the pixel 2 taken along the line segment A-B illustrated in the left diagram of Fig. 10 is the same as the cross-sectional configuration example of the pixel 2 taken along the line segment A-B illustrated in the left diagram of Fig. 5. That is, the gate electrode AG1 of the assist transistor 61-1 and the gate electrode AG1 of the assist transistor 61-2 are formed along the side surface of the inter-pixel separation section 52 from the position P1 of a front surface to the position of the position P2 in a depth direction.

Reference will be made to the right diagram of Fig. 10. The gate electrode AG2 of the assist transistor 61-3 is formed along the side surface of the inter-pixel separation section 52 from the position P1 of the front surface to the position of the position P3 in the depth direction. The gate electrode AG2 of the assist transistor 61-4 is formed along the side surface of the inter-pixel separation section 52 from the position P1 of the front surface to the position of the position P3. The gate electrode AG2 of the assist transistor 61-3 and the gate electrode AG2 of the assist transistor 61-4 are formed to the same depth in the depth direction.

The pixel 2 according to the second embodiment is different from the pixel 2 according to the first embodiment in that the gate electrode AG1 and the gate electrode AG2 are formed to have portions overlapping each other in the depth direction, and the other points are the same.

### Operation of Assist Transistor 61

A change in a sensor potential when the pixel 2 including the assist transistor 61 illustrated in Fig. 10 is driven in a drive mode based on the timing chart illustrated in Fig. 6 will be described with reference to Fig. 11. The graph illustrated in Fig. 11 is a graph showing the change in the sensor potential in the depth direction at the time of accumulation and at the time of readout, similarly to the graph illustrated in Fig. 7.

The graph at the time of accumulation indicated by the solid line is the same as the graph illustrated in Fig. 7. When the gate electrodes AG1 and AG2 are driven and a predetermined voltage is applied to each of the gate electrodes at the time of readout, the sensor potential in a range affected by the voltage due to the gate electrodes AG1 and AG2 is as shown by the dotted line. The sensor potential is modulated in the range affected by the voltage of only the gate electrode AG2 and the range affected by the voltages of both the gate electrode AG1 and the gate electrode AG2. A saturation charge amount (Qs) can be increased by the difference between the graph of the modulated sensor potential indicated by the dotted line and the graph of the sensor potential at the time of accumulation indicated by the solid line.

The gate electrodes AG1 and AG2 are provided up to a position close to the surface on which the transfer transistor 53 is formed. By applying a negative voltage to the gate electrode AG1 and the gate electrode AG2, the potential on a Si surface (front surface) side can be further lowered, and thus, even when the bias of the transfer transistor 53 is set to be lower than a predetermined value, transfer can be performed. Therefore, the voltage applied to the transfer transistor 53 can be reduced, and the power consumption can be reduced.

A change in the sensor potential when the pixel 2 including the assist transistor 61 illustrated in Fig. 10 is driven in a non-drive mode based on the timing chart illustrated in Fig. 8 will be described with reference to Fig. 12. The graph illustrated in Fig. 12 is a graph showing the change in the sensor potential in the depth direction at the time of accumulation and at the time of readout, similarly to the graph illustrated in Fig. 7.

The graph at the time of accumulation indicated by the solid line is the same as the graph illustrated in Fig. 7. When only the gate electrode AG2 is driven and a predetermined voltage is applied at the time of readout, the sensor potential in the range affected by the voltage due to the gate electrode AG2 is as shown by the dotted line. Since the gate electrode AG2 is provided up to the vicinity of the Si surface (front surface), the sensor potential is modulated up to the vicinity of the front surface.

The graph of the sensor potential indicated by the dotted line illustrated in Fig. 11 is compared with the graph of the sensor potential indicated by the dotted line illustrated in Fig. 12. It can be read that the graph of the sensor potential indicated by the dotted line in Fig. 11 has a larger modulated range in a negative direction by the amount by which the gate electrode AG1 is driven in the drive mode. In also the non-drive mode, the sensor potential can be modulated up to the vicinity of the front surface, but the modulated range is smaller than that in the drive mode. As a result, a potential gradient can be increased.

Even in the case of a configuration in which the gate electrode AG1 and the gate electrode AG2 are provided up to the front surface side, the transfer gradient can be increased, transfer efficiency can be improved, and the saturation charge amount (Qs) can be increased.

### Third Embodiment

Fig. 13 is a diagram depicting a planar configuration example of the pixel 2 according to a third embodiment. The pixel 2 according to the third embodiment is different from the pixel 2 (Fig. 4) according to the first and second embodiments in the positions where the gate electrodes AG1 and the gate electrodes AG2 are arranged.

Referring again to Fig. 4, in the pixel 2 according to the first embodiment, the gate electrode AG1 is disposed on the upper side and the lower side of the inter-pixel separation section 52 in the figure, that is, at positions facing each other, and the gate electrode AG2 is disposed on the left side and the right side of the inter-pixel separation section 52 in the figure, that is, at positions facing each other. Such an arrangement is appropriately described as a facing arrangement.

In the pixel 2 according to the third embodiment illustrated in Fig. 13, the gate electrodes AG1 are arranged on the upper side and the right side of the inter-pixel separation section 52 in the figure, that is, at positions having an angle of 90 degrees. Similarly, the gate electrodes AG2 are arranged at the left side and the lower side of the inter-pixel separation section 52 in the figure, that is, at positions having an angle of 90 degrees. Such an arrangement is described as an L-shaped arrangement as appropriate below because the gate electrodes AG are arranged on the sides of the L shape.

In the case of combining the third embodiment and the first embodiment, the gate electrode AG1 and the gate electrode AG2 are formed to have different depths so as not to have a portion overlapping in a depth direction. In other words, the gate electrode AG1 is disposed at a position and with a size that modulate the sensor potential near a front surface, and the gate electrode AG2 is disposed at a position and with a size that modulate a sensor potential at a deep position. When the pixel 2 having such a configuration is driven in a drive mode illustrated in Fig. 6, the sensor potential illustrated in Fig. 7 can be obtained. When the pixel 2 having such a configuration is driven in a non-drive mode illustrated in Fig. 8, the sensor potential illustrated in Fig. 9 can be obtained.

In the case of combining the third embodiment and the second embodiment, the gate electrode AG1 and the gate electrode AG2 are formed to have a portion overlapping in the depth direction. In other words, the gate electrode AG1 is disposed at a position and with a size that modulate the sensor potential near the front surface, and the gate electrode AG2 is also disposed at a position and with a size that modulate the sensor potential from near the front surface to a deep position. When the pixel 2 having such a configuration is driven in the drive mode illustrated in Fig. 6, the sensor potential illustrated in Fig. 11 can be obtained. When the pixel 2 having such a configuration is driven in the non-drive mode illustrated in Fig. 8, the sensor potential illustrated in Fig. 12 can be obtained.

In the L-shaped arrangement, as in the facing arrangement, a transfer gradient can be increased, the transfer efficiency can be improved, and a saturation charge amount (Qs) can be increased.

### Fourth Embodiment

Fig. 14 is a diagram depicting a planar configuration example of the pixel 2 according to a fourth embodiment. The pixel 2 according to the fourth embodiment is different from the pixels 2 according to the first to third embodiments in the positions of arrangement of the gate electrodes AG1 and the gate electrodes AG2.

Each of the gate electrodes AG of the assist transistors 61-1 to 61-4 of the pixel 2 illustrated in Fig. 14 is different from that of the pixels 2 of the first to third embodiments in that the entire gate electrode AG is located in the inter-pixel separation section 52.

In the pixel 2 illustrated in Fig. 14, the gate electrode AG1 of the assist transistor 61-1 is formed within the upper side of the inter-pixel separation section 52 in the figure, and the gate electrode AG1 of the assist transistor 61-2 is formed within the lower side of the inter-pixel separation section 52 in the figure. The gate electrode AG2 of the assist transistor 61-3 is formed within the left side of the inter-pixel separation section 52 in the figure, and the gate electrode AG1 of the assist transistor 61-4 is formed within the right side of the inter-pixel separation section 52 in the figure.

In this manner, the gate electrode AG of an assist transistor 64 is embedded in the inter-pixel separation section 52.

Although the case where the arrangement of the gate electrodes AG1 and the arrangement of the gate electrodes AG2 are the facing arrangement is shown, it may be the L-shaped arrangement. In other words, although the case where the fourth embodiment is applied to the first embodiment (Fig. 4) has been described as an example in Fig. 14, the fourth embodiment may be applied to the third embodiment (Fig. 13).

Fig. 15 is a diagram depicting a cross-sectional configuration example of the pixel 2 taken along the line segment A-B in Fig. 14 and a cross-sectional configuration example of the pixel 2 taken along the line segment C-D in Fig. 14. Reference will be made to the left diagram of Fig. 15. The gate electrode AG1 of the assist transistor 61-1 is formed from the position P1 of a front surface to the position of the position P2 in a depth direction inside the inter-pixel separation section 52. In the gate electrode AG1 of the assist transistor 61-1, the left side, the right side, and the lower side in the figure are covered with a material forming the inter-pixel separation section 52. The upper side of the gate electrode AG1 is connected to the wiring line 81-1.

The gate electrode AG1 of the assist transistor 61-2 is formed from the position P1 of the front surface to the position of the position P2 inside the inter-pixel separation section 52. In the gate electrode AG1 of the assist transistor 61-2, the left side, the right side, and the lower side in the figure are covered with the material forming the inter-pixel separation section 52. The upper side of the gate electrode AG1 is connected to the wiring line 81-2.

The gate electrode AG1 of the assist transistor 61-1 and the gate electrode AG1 of the assist transistor 61-2 are formed to the same depth in the depth direction of the inter-pixel separation section 52.

Reference will be made to the right diagram of Fig. 15. The gate electrode AG2 of the assist transistor 61-3 is formed from the position P2 to the position of the position P3 in the depth direction inside the inter-pixel separation section 52. In the gate electrode AG2 of the assist transistor 61-3, the left side, the right side, the upper side, and the lower side in the figure are covered with the material forming the inter-pixel separation section 52. The upper side of the gate electrode AG2 is connected to the wiring line 81-3 that is formed also in the inter-pixel separation section 52.

The gate electrode AG2 of the assist transistor 61-4 is formed from the position P2 of the front surface to the position of the position P3 inside the inter-pixel separation section 52. In the gate electrode AG2 of the assist transistor 61-4, the left side, the right side, the upper side, and the lower side in the figure are covered with the material forming the inter-pixel separation section 52. The upper side of the gate electrode AG2 is connected to the wiring line 81-4 that is formed also in the inter-pixel separation section 52.

The gate electrode AG2 of the assist transistor 61-3 and the gate electrode AG2 of the assist transistor 61-4 are formed to the same depth in the depth direction of the inter-pixel separation section 52.

The gate electrode AG2 may be formed from the position P1 to the position P3. In other words, although the case where the fourth embodiment is applied to the first embodiment (Fig. 4) has been described as an example in Fig. 14, the fourth embodiment may be applied to the second embodiment (Fig. 10).

By adopting a structure in which the gate electrode AG1 and the gate electrode AG2 each are embedded in the inter-pixel separation section 52, the region occupied by the gate electrode AG can be set to be outside the region where the PD 51 is provided, the region that can be used as the PD 51 is expanded, a saturation charge amount can be improved, and sensibility can be improved.

In the case of the configuration in which the gate electrode AG is embedded in the inter-pixel separation section 52, even when the gate electrode AG is formed larger than the size illustrated in Fig. 14, the gate electrode AG can be provided so as not to be in contact with the gate electrode TG of the transfer transistor 53. The gate electrodes AG1 and AG2 can be formed larger than the size illustrated in Fig. 14, and the design freedom of the shape can be increased.

Although an example in which both the gate electrode AG1 and the gate electrode AG2 are embedded in the inter-pixel separation section 52 has been described, a configuration in which one of the gate electrode AG1 and the gate electrode AG2 is embedded in the inter-pixel separation section 52 and the other is partially embedded in the inter-pixel separation section 52 (the configuration in the first to third embodiments) may be adopted.

In the fourth embodiment, as in the first to third embodiments, a transfer gradient can be increased, transfer efficiency can be improved, and the saturation charge amount (Qs) can be increased.

### Regarding Number of Assist Transistors 61

In the first to fourth embodiments, the example in which the four assist transistors 61-1 to 61-4 are provided and the four gate electrodes AG corresponding to the assist transistors 61-1 to 61-4 are provided has been described.

As illustrated in Fig. 16, a configuration may also be adopted in which one assist transistor 61-1 is provided and one gate electrode AG1 corresponding thereto is provided. In the planar configuration example of the pixel 2 illustrated in Fig. 16, the assist transistor 61-1 is provided, and the gate electrode AG1 is provided on the upper side of the inter-pixel separation section 52 in the figure.

In a case where one assist transistor 61 is provided, the assist transistor 61 may be provided on any side of the lower side, the left side, and the right side without being limited to the upper side of the inter-pixel separation section 52. The gate electrode AG to be provided may be, not the gate electrode AG1, but the gate electrode AG2 that is formed at a deep position.

As illustrated in Fig. 17, a configuration may also be adopted in which two assist transistors 61-3 and 61-4 are included and two gate electrodes AG2 corresponding thereto are provided. In the planar configuration example of the pixel 2 illustrated in Fig. 17, the assist transistor 61-3 and the assist transistor 61-4 are provided, and the gate electrodes AG2 are provided on the left side and the lower side of the inter-pixel separation section 52 in the figure, respectively.

In a case where two assist transistors 61 are provided, not limited to the configuration in which the assist transistors 61 are provided on the left side and the lower side, the assist transistors 61 may be provided on any two sides of the upper side, the lower side, the left side, and the right side of the inter-pixel separation section 52.

By providing at least one assist transistor 61, the transfer gradient can be increased, the transfer efficiency can be improved, and the saturation charge amount (Qs) can be increased.

Four or more assist transistors 61 may be provided in one pixel. For example, two or more gate electrodes AG may be provided in a horizontal direction (X-axis or Y-axis direction) or two or more gate electrodes AG may be provided in the depth direction (Z-axis direction) on the same side of the inter-pixel separation section 52.

### Fifth Embodiment

As a fifth embodiment, a case where the present technology is applied to a phase difference pixel will be described as an example. Fig. 18 is a diagram depicting a planar configuration example of the pixel 2 (hereinafter, appropriately described as the phase difference pixel 2) which is a phase difference pixel in the fifth embodiment, and Fig. 19 is a diagram depicting a cross-sectional configuration example of the phase difference pixel 2 taken along the line segment E-F in Fig. 18.

The phase difference pixel 2 is a pixel provided in the pixel array section 3 in order to realize an autofocus (AF) function, and is a pixel in which a region surrounded by the inter-pixel separation section 52 is divided into two regions as depicted in Fig. 18. A phase difference is calculated according to signals obtained from the respective two regions provided in the pixel 2, and the position of the lens or the like is adjusted according to the phase difference, thereby realizing autofocus.

In the phase difference pixel 2 depicted in Fig. 18, a region on the left side is referred to as a pixel 2a, and a region on the right side is referred to as a pixel 2b. The pixel 2a includes a PD 51a, and the pixel 2b includes a PD 51b. In the pixel 2a, the gate electrode TG of a transfer transistor 53a is provided on the upper side of the PD 51a in the figure. A FD 54a is provided at the upper right corner in the pixel 2a in the figure. The lower left side in the figure is a GND. The pixel 2a is configured to have a potential gradient from the GND toward the gate electrode TG in plan view.

The gate electrode AG2 of an assist transistor 61a-3 is provided on the side of the inter-pixel separation section 52 on the left side in the figure of the inter-pixel separation section 52 surrounding the pixel 2a, and the gate electrode AG2 of an assist transistor 61a-4 is provided on the side of the inter-pixel separation section 52 on the lower right side in the figure. A gate electrode AG3 of an assist transistor 61a-5 is provided on the side of the inter-pixel separation section 52 on the lower side of the pixel 2a in the figure.

In the pixel 2b, the gate electrode TG of a transfer transistor 53b is provided on the upper side of the PD 51b in the figure. A FD 54b is provided at the upper left corner in the pixel 2b in the figure. The lower right side in the figure is a GND. The pixel 2b is configured to have the potential gradient from the GND toward the gate electrode TG in plan view.

The gate electrode AG2 of an assist transistor 61b-3 is provided on the side of the inter-pixel separation section 52 on the right side in the figure of the inter-pixel separation section 52 surrounding the pixel 2b, and the gate electrode AG2 of the assist transistor 61b-4 is provided on the side of the inter-pixel separation section 52 on the lower right side in the figure. The gate electrode AG3 of an assist transistor 61b-5 is provided on the side of the inter-pixel separation section 52 on the lower side of the pixel 2b in the figure.

Fig. 19 is a diagram depicting a cross-sectional configuration example of the pixel 2 taken along the line segment E-F in Fig. 18. The gate electrode AG2 of the assist transistor 61a-3 of the pixel 2a illustrated on the left side in the figure is formed along the side surface of the inter-pixel separation section 52 from the position P1 of a front surface to the position of the position P3 in a depth direction. The gate electrode AG2 of the assist transistor 61a-4 is formed along the side surface of the inter-pixel separation section 52 from the position P1 of the front surface to the position of the position P3. The gate electrode AG2 of the assist transistor 61a-3 and the gate electrode AG2 of the assist transistor 61a-4 are formed to the same depth in the depth direction. The gate electrode AG3 of the assist transistor 61a-5 is formed from the position P2 to the position P3 of the pixel 2a.

The gate electrode AG2 of the assist transistor 61b-3 of the pixel 2b illustrated on the right side in the figure is formed along the side surface of the inter-pixel separation section 52 from the position P1 of the front surface to the position of the position P3 in the depth direction. The gate electrode AG2 of the assist transistor 61b-4 is formed along the side surface of the inter-pixel separation section 52 from the position P1 of the front surface to the position of the position P3. The gate electrode AG2 of the assist transistor 61b-3 and the gate electrode AG2 of the assist transistor 61b-4 are formed to the same depth in the depth direction. The gate electrode AG3 of the assist transistor 61b-5 is formed from the position P2 to the position P3 of the pixel 2b.

In Fig. 19, the case where the fifth embodiment is applied to the second embodiment (Fig. 10) has been described as an example. The fifth embodiment may be applied to the first embodiment (Fig. 4) to form a structure in which the gate electrode AG2 is formed from the position P1 to the position P2. Further, the fifth embodiment may be applied to the fourth embodiment (Fig. 15) to form a structure in which the gate electrode AG2 is embedded in the inter-pixel separation section 52.

The gate electrode AG3 may also be embedded in the inter-pixel separation section 52. The gate electrode AG3 may be formed from the position P1 to the position P3, as in the case of the gate electrode AG2.

### Operation of Assist Transistor 61

An operation related to readout of charge from the PD 51 of the phase difference pixel 2 depicted in Figs. 18 and 19 will be described with reference to a timing chart of Fig. 20. Note that the operation related to the readout in the pixel 2a and the operation related to the readout in the pixel 2b can be the same, and thus the pixel 2a will be described as an example.

At a time T21 when the readout of the charge from the PD 51 is started, the transfer signal TRG is supplied to the transfer transistor 53a, and the transfer transistor 53a is turned on. At a time T22 when a predetermined time has elapsed from the time T21, the assist signal AG2 is supplied to each of the assist transistor 61a-3 and the assist transistor 61a-4, and the assist transistor 61a-3 and the assist transistor 61a-4 are turned on. When the assist transistor 61a-3 is turned on, a predetermined negative voltage is applied to the assist transistor 61a-3, and when the assist transistor 61a-4 is turned on, a predetermined negative voltage is applied to the assist transistor 61a-4.

At a time T23, when the readout of the charge from the PD 51 is ended, the transfer transistor 53a and the assist transistors 61a-3 and 61a-4 are returned to an off state.

A negative voltage (fixed voltage) is always applied to the assist transistor 61a-5 (gate electrode AG3).

A change in a sensor potential when the operation illustrated in Fig. 20 is performed will be described with reference to Fig. 21. The graph illustrated in Fig. 21 is a graph showing the change in the sensor potential in the depth direction at the time of accumulation and at the time of readout, similarly to the graph illustrated in Fig. 7.

The graph at the time of accumulation indicated by the solid line is the same as the graph illustrated in Fig. 7. At the time of readout, in addition to the modulation of the sensor potential by the gate power supply AG3 to which a predetermined voltage is applied, the modulation of the sensor potential by the gate electrode AG2, to which a predetermined voltage is applied due to the gate electrode AG2 being driven, is also added. The sensor potential in a range affected by the voltages due to the two gate power supplies AG is as indicated by the thin dotted line in Fig. 21. As compared with the graph of the solid line at the time of accumulation, the graph moves to the minus side, the difference in the graph between the solid line and the dotted line is large, and it can be read that a saturation charge amount (Qs) increases by that amount.

Since the gate electrode AG2 is provided up to the vicinity of the Si surface (front surface), the sensor potential is modulated up to the vicinity of the front surface by the influence of the voltage due to the gate electrode AG2. A region where the sensor potential changes steeply can be created near the boundary between the range where the sensor potential is affected by the voltage due to the gate electrode AG3 and the range where the sensor potential is not affected by the voltage due to the gate electrode AG3. This makes it possible to increase a transfer gradient and improve transfer efficiency. In addition, the saturation charge amount (Qs) can be increased.

### Other Arrangement of Assist Transistor 61

Fig. 22 is a diagram depicting another planar configuration example of the phase difference pixel 2 according to the fifth embodiment. The phase difference pixel 2 depicted in Fig. 22 is different from the phase difference pixel 2 depicted in Fig. 18 in that the gate electrodes AG2 of the assist transistor 61a-3 and the assist transistor 61b-3 are formed to be longer, and the other points are the same.

The gate electrode AG2 of the assist transistor 61a-3 included in the pixel 2a of the phase difference pixel 2 illustrated in Fig. 22 is formed from the upper side to the lower side of the inter-pixel separation section 52 in the figure. The gate electrode AG2 of the assist transistor 61b-3 included in the pixel 2b of the phase difference pixel 2 is formed from the upper side to the lower side of the inter-pixel separation section 52 in the figure.

In the phase difference pixel 2 depicted in Fig. 22, the gate electrode AG of the assist transistor 61 is formed on the end side of the gate electrode TG of the transfer transistor 53, which is not the FD portion 54 side. With such a configuration, a potential gradient from the gate electrode AG toward the FD portion 54 can be provided. For example, in the pixel 2a, the end side of the gate electrode TG of the transfer transistor 53, which is not the FD portion 54a side, is the inter-pixel separation section 52 on the left side in the figure, and the gate electrode AG2 is provided in the inter-pixel separation section 52. The potential gradient from the gate electrode AG2 toward the FD portion 54a can be created. In addition, since a potential can be provided in the gate electrode TG of the transfer transistor 53, an effect of suppressing a potential Dip (pocket) can also be obtained.

Fig. 23 is a diagram depicting still another planar configuration example of the phase difference pixel 2 according to the fifth embodiment. The gate electrode AG2 of the assist transistor 61a-3 included in the pixel 2a of the phase difference pixel 2 depicted in Fig. 23 is formed in a triangular shape at the corner of the inter-pixel separation section 52 on the lower left in the figure. The gate electrode AG3 of the assist transistor 61a-5 included in the pixel 2a is formed in a triangular shape at the corner of the inter-pixel separation section 52 on the lower right in the figure.

The gate electrode AG2 of the assist transistor 61b-3 included in the pixel 2b of the phase difference pixel 2 illustrated in Fig. 23 is formed in a triangular shape at the corner of the inter-pixel separation section 52 on the lower right in the figure. The gate electrode AG3 of the assist transistor 61b-5 included in the pixel 2b is formed in a triangular shape at the corner of the inter-pixel separation section 52 on the lower left in the figure.

As depicted in Fig. 23, the gate electrode AG may be formed in a triangular shape. The embodiment in which the gate electrode AG is formed in a triangular shape at the corner portion of the inter-pixel separation section 52 can also be applied to the first to fourth embodiments.

In the phase difference pixel 2 depicted in Fig. 23, a fixed negative voltage is supplied to the gate electrodes AG3 of the assist transistors 61a-5 and 61b-5, as in the case described with reference to Fig. 20. In the phase difference pixel 2 depicted in Fig. 23, the gate electrodes AG2 of the assist transistors 61a-4 and 61b-4 may be arranged instead of the gate electrodes AG3 of the assist transistors 61a-5 and 61b-5, and a predetermined voltage may be supplied with a pulse.

In also the fifth embodiment, as in the first to fourth embodiments, the transfer gradient can be increased, the transfer efficiency can be improved, and the saturation charge amount (Qs) can be increased.

In the above-described embodiment, the description has been made in which a negative voltage is supplied to the gate electrode AG, but a configuration in which a positive voltage is supplied thereto can also be adopted. The magnitude and phase of the voltage applied to the gate electrode AG can be set as appropriate depending on what kind of sensor potential is desired to be obtained in accordance with the characteristics of the pixel 2.

The case where the gate electrode AG in the above-described embodiment is configured to be partially embedded in the inter-pixel separation section 52 or completely included in the inter-pixel separation section 52 has been described as an example. The gate electrode AG may be formed at a position away from the inter-pixel separation section 52, in other words, may be formed so as not to be in contact with the inter-pixel separation section 52.

Since the gate electrode AG is provided in the portion of the inter-pixel separation section 52, the gate electrode AG may be provided as a part of the inter-pixel separation section 52, that is, a part of a portion having a function of physically separating pixels from each other. For example, in the phase difference pixel 2 depicted in Fig. 22, a structure may be applied in which the gate electrode AG1 of the assist transistor 61a-3 provided on the left side in the figure constitutes one side of the inter-pixel separation section 52, and the inter-pixel separation section 52 of this portion (left side) is removed or formed to be thin, and the gate electrode AG1 functions as the inter-pixel separation section 52.

### Sixth Embodiment

Fig. 24 is a diagram depicting a planar configuration example of the pixel 2 according to a sixth embodiment, and Fig. 25 is a diagram depicting a cross-sectional configuration example of the pixel 2 taken along the line segment G-H in Fig. 24 and a cross-sectional configuration example of the pixel 2 taken along the line segment I-J in Fig. 24. The same parts as those of the pixel 2 in the first embodiment are denoted by the same reference signs, and description thereof will be omitted as appropriate.

In the first to fifth embodiments, an example in which the FD 54 is provided at the corner of the pixel 2 in plan view has been described, but a configuration in which the FD 54 is located at the center can also be adopted. In a case where the FD 54 is located at the center of the pixel 2, the transfer transistor 53 in the first to fifth embodiments may be omitted, and only the assist transistor 61 may be provided.

In the pixel 2 according to the first to fifth embodiments, the case where the transfer of the charge from the PD 51 to the FD 54 is performed by the transfer transistor 53, and the assist of the charge transfer by the assist transistor 61 is performed so that the transfer by the transfer transistor 53 is efficiently performed without the charge remaining in the PD 51 has been described as an example.

In the pixel 2 according to the sixth embodiment, transfer is performed by a transfer transistor 101 having a gate electrode in a vertical direction similarly to the assist transistor 61 described above, and the transfer transistor 101 itself functions as a transistor that assists charge transfer similarly to the assist transistor 61 described above.

As illustrated in Fig. 24, the FD 54 is provided in a central region of the rectangular pixel 2. Although not illustrated in Fig. 24, the PD 51 is also provided in the central region of the rectangular pixel 2. For example, in a case where the PD 51 is formed by forming an N-type semiconductor region in a P-type semiconductor region in the semiconductor substrate 50 made of silicon (Si), the FD 54 is formed by the N-type semiconductor region having a high N-type impurity concentration.

A gate electrode TG of the transfer transistor 101 is provided on a side surface of the inter-pixel separation section 52. The inter-pixel separation section 52 located on the left side in the figure is provided with a gate electrode TG1 of a transfer transistor 101-1. The inter-pixel separation section 52 located on the right side in the figure is provided with the gate electrode TG1 of a transfer transistor 101-2.

The inter-pixel separation section 52 located on the upper side in the figure is provided with a gate electrode TG2 of a transfer transistor 101-3. The inter-pixel separation section 52 located on the lower side in the figure is provided with the gate electrode TG2 of a transfer transistor 101-4. Note that in the following description, when it is not necessary to distinguish the transfer transistors 101-1 to 101-4 from each other, the transfer transistors 101-1 to 101-4 are simply referred to as the transfer transistor 101. The other parts are described in the same manner.

When the charge is read out from the PD 51, the transfer transistor 101 is turned on, supplies a predetermined voltage, and modulates a potential in the pixel 2.

The line segment G-H is a line segment passing through the transfer transistor 101-1 and the transfer transistor 101-2, and a cross-sectional configuration of the pixel 2 taken along the line segment G-H is as illustrated in the left diagram of Fig. 25. The PD 51 is provided in a lower central portion of the semiconductor substrate 50 of the pixel 2, the FD 54 is provided above the PD 51, and a separation section 111 is provided between the PD 51 and the FD 54. The separation section 111 is, for example, a P-type semiconductor region. The inter-pixel separation section 52 is provided so as to surround a region including the PD 51.

The position of a front surface is defined as a position P11, and is defined as a reference position in a depth direction. The gate electrode TG1 of the transfer transistor 101-1 is formed along the side surface of the inter-pixel separation section 52 from the position P11 of the front surface to a position P12 in the depth direction. The gate electrode TG1 of the transfer transistor 101-2 is also formed from the position P11 of the front surface to the position P12 along the side surface of the inter-pixel separation section 52. The gate electrode TG1 of the transfer transistor 101-1 and the gate electrode TG1 of the transfer transistor 101-2 are formed to the same depth in the depth direction.

Referring to Fig. 24, the gate electrode TG1 of the transfer transistor 101-1 and the gate electrode TG1 of the transfer transistor 101-2 are gate electrodes arranged at positions facing each other. A pair of gate electrodes TG1 arranged at the positions facing each other are formed to the same depth in the depth direction.

Reference will be made to the right diagram of Fig. 25. The gate electrode TG2 of the transfer transistor 101-3 is formed along the side surface of the inter-pixel separation section 52 from the position P11 to a position P13 in the depth direction. The gate electrode TG2 of the transfer transistor 101-4 is formed along the side surface of the inter-pixel separation section 52 from the position P12 to the position P13 in the depth direction. The gate electrode TG2 of the transfer transistor 101-3 and the gate electrode TG2 of the transfer transistor 101-4 are formed to the same depth in the depth direction.

Referring to Fig. 24, the gate electrode TG2 of the transfer transistor 101-3 and the gate electrode TG2 of the transfer transistor 101-4 are gate electrodes arranged at positions facing each other. A pair of gate electrodes TG2 arranged at the positions facing each other are formed to the same depth in the depth direction.

When the gate electrodes TG1 of the transfer transistors 101-1 and 101-2 and the gate electrodes TG2 of the transfer transistors 101-3 and 101-4 are viewed, the gate electrodes TG1 and the gate electrodes TG2 are configured to have portions overlapping in the depth direction. Since the gate electrode TG1 is formed from the position P11 to the position P12 and the gate electrode TG2 is formed from the position P11 to the position P13, the gate electrode TG1 and the gate electrode TG2 are formed so as to overlap from the position P11 to the position P12.

The gate electrode TG1 and the gate electrode TG2 are provided at different depths in the depth direction such that there are a region where a sensor potential in the pixel 2 is modulated by the gate electrode TG1 and the gate electrode TG2 and a region where the sensor potential in the pixel 2 is modulated only by the gate electrode TG2. The region where the sensor potential in the pixel 2 is modulated by the gate electrodes TG1 and TG2 is the separation section 111 that separates the PD 51 and the FD 54, and the region where the sensor potential in the pixel 2 is modulated only by the gate electrode TG2 is the region of the PD 51.

The gate electrode TG1 of the transfer transistor 101-1 and the gate electrode TG1 of the transfer transistor 101-2 are connected to wiring lines (not illustrated) to which the transfer signals TG1 are respectively supplied. The gate electrode TG2 of the transfer transistor 101-3 and the gate electrode TG2 of the transfer transistor 101-4 are connected to wiring lines (not illustrated) to which the transfer signals TG2 are respectively supplied.

### Operation of Transfer Transistor 101 in Sixth Embodiment

An operation related to readout of the charge from the PD 51 of the pixel 2 including the transfer transistor 101 will be described with reference to a timing chart of Fig. 26 and a diagram for describing a change in the sensor potential at the time of accumulation and at the time of readout illustrated in Fig. 27.

Note that the transfer transistor 101-1 and the transfer transistor 101-2 are driven in the same manner, and therefore, the following description will be continued by taking the transfer transistor 101-1 as an example. Further, since the transfer transistor 101-3 and the transfer transistor 101-4 are driven in the same manner, the following description will be continued by taking the transfer transistor 101-3 as an example.

The numerical values shown in Figs. 26 and 27 are specific numerical values for the sake of description, but are examples and are not limited.

At the time T11, the charge is accumulated in the PD 51. When the charge is accumulated in the PD 51, both the transfer transistor 101-1 and the transfer transistor 101-3 are turned off. The off state of the transfer transistor 101-1 is, for example, a state in which the voltage of -1.2 V is applied. The off state of the transfer transistor 101-3 is, for example, a state in which the voltage of 0 V is applied.

Referring to a potential diagram at the time T11 in Fig. 27, the charge corresponding to the amount of light received by the PD 51 is accumulated, and the PD 51 and the FD 54 are separated by the barrier of the separation section 111.

Returning to the description with reference to Fig. 26, at the time T12, the transfer signal TG1 is supplied to the transfer transistor 101-1, and the transfer transistor 101-1 is turned on. The on state of the transfer transistor 101-1 is, for example, a state in which the voltage of 2.8 V is applied. At the time T12, the transfer signal TG2 (appropriately referred to as a first transfer signal TG2) is supplied to the transfer transistor 101-3, and the transfer transistor 101-3 is turned on (appropriately referred to as a first on state). The first on state of the transfer transistor 101-3 is, for example, a state in which the voltage of 2.8 V is applied.

At the time T12, the transfer of the charge accumulated in the PD 51 to the FD 54 is started. Reference will be made to a potential diagram at the time T12 in Fig. 27. The region of the separation section 111 is a region that receives modulation by a pair of the transfer transistor 101-1 and the transfer transistor 101-2 (TG1 in Fig. 27) and modulation by a pair of the transfer transistor 101-3 and the transfer transistor 101-4 (TG2 in Fig. 27). The potential of the separation section 111 modulated by the two pairs of gate electrodes sinks deeply, and the barrier of the separation section 111 can be lowered, so that the transfer of the charge from the PD 51 to the FD 54 can be more reliably performed.

The transfer transistors 101-3 and 101-4 (TG2 in Fig. 27) are provided to a position deeper than the transfer transistors 101-1 and 101-2 (TG1 in Fig. 27), and a part thereof is provided to a position where the region where the PD 51 is provided can be modulated. Therefore, a part of the PD 51 is also modulated by the transfer transistors 101-3 and 101-4, and thus the potential of a part of the region of the PD 51 (a region on the side close to the FD 54) is lowered as illustrated in Fig. 27. The potential of the PD 51 on the FD 54 side is lowered, and thus, a situation is achieved in which the transfer from the PD 51 to the FD 54 is easier, and the transfer of the charge from the PD 51 to the FD 54 can be more reliably performed.

Returning to the description with reference to Fig. 26. When a predetermined time has elapsed since the transfer (readout) of the charge from the PD 51 to the FD 54 is started at the time T12 and the time T13 is reached, the transfer transistor 101-3 is turned off. The off state of the transfer transistor 101-3 is, for example, a state in which the voltage of 0 V is applied. At the time T13, the state in which the transfer signal TG1 is supplied to the transfer transistor 101-1 is maintained, and the transfer transistor 101-1 is maintained in the on state.

Reference will be made to a potential diagram at the time T13 in Fig. 27. In the region of the separation section 111, the magnitude of the modulation by the pair of the transfer transistor 101-1 and the transfer transistor 101-2 (TG1 in Fig. 27) does not change, and the modulation by the pair of the transfer transistor 101-3 and the transfer transistor 101-4 (TG2 in Fig. 27) is reduced, and as a result, the potential rises more than the state at the time T12.

Since the region of the PD 51 on the FD 54 side is modulated by the transfer transistors 101-3 and 101-4 (TG2 in Fig. 27), and the modulated state changes from the first on state (2.8 V state) to the off state (0 V state), the potential is higher than that in the state at the time T12. In the state at the time T13, the potential of the separation section 111 is lower than the potential of the modulated region of the PD 51, and thus the charge remaining in the PD 51 is transferred to the separation section 111. Therefore, a situation in which all the charge remaining in the PD 51 can be transferred to the separation section 111 (FD 54) can be provided, and the transfer of the charge from the PD 51 to the FD 54 can be more reliably performed.

Returning to the description with reference to Fig. 26. At a time T14, which is a time point before the transfer (readout) of the charge from the PD 51 to the FD 54 is ended after a predetermined time has elapsed from the time T13, the transfer transistor 101-1 is turned off, and a voltage is set to -1.2 V. At the time T14, the transfer signal TG2 (appropriately referred to as the second transfer signal TG2) is supplied to the transfer transistor 101-3, and the transfer transistor 101-3 is turned on (appropriately referred to as a second on state). The second on state of the transfer transistor 101-3 is, for example, a state in which the voltage of -1.2 V is applied.

Reference will be made to a potential diagram at the time T1 in Fig. 27. In the region of the separation section 111, the direction of modulation by the pair of the transfer transistor 101-1 and the transfer transistor 101-2 (TG1 in Fig. 27) changes, and the direction of modulation by the pair of the transfer transistor 101-3 and the transfer transistor 101-4 (TG2 in Fig. 27) also changes, and as a result, the potential rises from the state at the time T13, and becomes a potential that sufficiently functions as a barrier that prevents charges from flowing from the PD 51 to the FD 54. In addition, when the potential of the separation section 111 rises, the charge in the separation section 111 moves toward the FD 54, and thus the transfer of the charge from the PD 51 to the FD 54 can be more reliably performed.

Since the region of the PD 51 on the FD 54 side is modulated by the transfer transistors 101-3 and 101-4 (TG2 in Fig. 27) and the modulated state changes from the off state (0 V state) to the second on state (-1.2 V state), the potential is higher than that in the state at the time T13. In the state at the time T14, the potential of the modulated region of the PD 51 is higher than the potential of the non-modulated region of the PD 51, and thus it is possible to suppress the reverse flow or the pumping of the charge from the FD 54 to the PD 51. As a result, the transfer of the charge from the PD 51 to the FD 54 can be more reliably performed.

Returning to the description with reference to Fig. 26. When a predetermined time has elapsed from the time T14 and a time T15 at which the transfer (readout) of the charges from the PD 51 to the FD 54 is ended is reached, the transfer transistor 101-1 is maintained in the off state, and the transfer transistor 101-3 is switched to the off state (set to 0 V). This state is the same as the state at the time T11.

As described above, the pixel 2 to which the present technology is applied has a structure in which two gate electrodes TG1 arranged at positions facing each other and two gate electrodes TG2 arranged at positions facing each other are provided, and the separation section 111 that separates the PD 51 and the FD 54 is sandwiched between the four gate electrodes TG. The gate electrode TG2 is provided to a depth at which the PD 51 is provided so as to modulate a part of the PD 51, to be specific, a region of the PD 51 on the FD 54 side, and the depth is set to a position deeper than the depth at which the gate electrode TG1 is provided.

The pair of gate electrodes TG1 and the pair of gate electrodes TG2 are configured to be able to independently control the voltage values of the voltages to be applied and the timings of application.

The pair of gate electrodes TG1 is configured to have two states, on and off, in other words, a state of a first voltage (e.g., 2.8 V) and a state of a second voltage (e.g., -1.2 V). The pair of gate electrodes TG2 is configured to have three states, first on, second on, and off, in other words, a state of the first voltage (e.g., 2.8 V), a state of the second voltage (e.g., -1.2 V), and a state of a third voltage (e.g., 0 V).

In the pixel 2 having such a structure, it is possible to further improve the potential modulation of the separation region (separation section 111) between the PD 51 and the FD 54, and the separation by the separation region at the time of charge accumulation by the PD 51 can be strengthened, and a saturation signal amount can be increased. During charge transfer from the PD 51, the potential of the separation region can be made deeper, a gradient can be increased, and the charge transfer can be improved.

The modulation region can be changed by providing the gate electrodes TG1 and TG2 having different depths. Further, by independently driving the voltages set to the gate electrode TG1 and the gate electrode TG2, it is possible to adjust the potential difference between the separation region and the PD 51 (the shallow portion thereof), and the charge transfer can be further improved. Further, the separation between the PD 51 and the FD 54 can be deepened by the modulation of the gate electrode TG1 and the gate electrode TG2, the potential of the PD 51 region can be deepened only by the gate electrode TG2, the gradient can be strengthened, and the transfer can be further improved.

By providing the second voltage state (intermediate voltage state) in the gate electrode TG2, it is possible to transfer the charge remaining in the PD 51 to the separation section 111 and further to the FD 54, and it is also possible to prevent the charge from returning to the PD 51.

### Seventh Embodiment

Fig. 28 is a diagram depicting a cross-sectional configuration example of the pixel 2 according to a seventh embodiment. In the pixel 2 according to the seventh embodiment depicted in Fig. 28, the same parts as those of the pixel 2 (Fig. 25) according to the sixth embodiment are denoted by the same reference signs, and the description thereof will be omitted as appropriate.

The pixel 2 according to the seventh embodiment is different from the pixel 2 (Fig. 25) according to the sixth embodiment in that a sidewall 131 is added, and the other points are the same.

A sidewall 131-1 is provided on a side surface of the gate electrode TG1 of the transfer transistor 101-1, which is a surface on the opposite side to the inter-pixel separation section 52. A sidewall 131-2 is provided on a side surface of the gate electrode TG1 of the transfer transistor 101-2, which is a surface on the opposite side to the inter-pixel separation section 52.

A sidewall 131-3 is provided on a side surface of the gate electrode TG2 of the transfer transistor 101-3, which is a surface on the opposite side to the inter-pixel separation section 52. A sidewall 131-4 is provided on a side surface of the gate electrode TG2 of the transfer transistor 101-4, which is a surface on the opposite side to the inter-pixel separation section 52.

The sidewall 131 functions as an insulating film and is formed of an insulating material.

The sidewall 131-1 provided on the side surface of the gate electrode TG1 of the transfer transistor 101-1 is formed along the side surface of the gate electrode TG1 from the position P11 of a front surface to a position P21 in a depth direction. The sidewall 131-2 provided on the side surface of the gate electrode TG1 of the transfer transistor 101-2 is also formed along the side surface of the gate electrode TG1 from the position P11 of the front surface to the position P21 in the depth direction. The sidewall 131-1 on the transfer transistor 101-1 side and the sidewall 131-2 on the transfer transistor 101-2 side are formed to the same depth in the depth direction.

The position P21 is a position shallower than the position P12. The position P12 is a position at a depth at which the gate electrode TG1 of the transfer transistor 101-1 is provided. In the depth direction, the sidewall 131-1 of the transfer transistor 101-1 is formed to be shorter than the gate electrode TG1 of the transfer transistor 101-1, and is provided on a part of the gate electrode TG1 of the transfer transistor 101-1. Similarly, in the depth direction, the sidewall 131-2 of the transfer transistor 101-2 is formed to be shorter than the gate electrode TG1 of the transfer transistor 101-2, and is provided on a part of the gate electrode TG1 of the transfer transistor 101-2.

The FD 54 is provided from the position P11 to the position P21. The sidewall 131-1 and the sidewall 131-2 each are formed to a depth substantially the same as that of the FD 54. Note that although the description is continued here by taking an example in which they are provided to substantially the same depth, the sidewalls 131-1 and 131-2 may be provided to a deeper position than the FD 54.

The sidewall 131-3 provided on the side surface of the gate electrode TG2 of the transfer transistor 101-3 is formed along the side surface of the gate electrode TG2 from the position P11 of the front surface to a position P22 in the depth direction. The sidewall 131-4 provided on the side surface of the gate electrode TG2 of the transfer transistor 101-4 is also formed along the side surface of the gate electrode TG2 from the position P11 of the front surface to the position P22 in the depth direction. The sidewall 131-3 on the transfer transistor 101-3 side and the sidewall 131-4 on the transfer transistor 101-4 side are formed to the same depth in the depth direction.

The position P22 is a position shallower than the position P13. The position P13 is a position at a depth at which the gate electrode TG2 of the transfer transistor 101-3 is provided. In the depth direction, the sidewall 131-3 of the transfer transistor 101-3 is formed to be shorter than the gate electrode TG2 of the transfer transistor 101-3, and is provided on a part of the gate electrode TG2 of the transfer transistor 101-3. Similarly, in the depth direction, the sidewall 131-4 of the transfer transistor 101-4 is formed to be shorter than the gate electrode TG2 of the transfer transistor 101-4, and is provided on a part of the gate electrode TG2 of the transfer transistor 101-2.

When the sidewalls 131-1 and 131-2 are compared with the sidewalls 131-3 and 131-4, the sidewalls 131-3 and 131-4 are formed to a deeper position than the sidewalls 131-1 and 131-2.

Since the sidewall 131 is provided between the gate electrode TG and the FD 54, capacitance and an electric field between the gate electrode TG and the FD 54 can be relaxed. By providing the sidewall 131, the separation section 111 is divided into a region in which a sensor potential in the pixel 2 is modulated only by the gate electrode TG1, a region in which the sensor potential in the pixel 2 is modulated by the gate electrode TG1 and the gate electrode TG2, and a region in which the sensor potential in the pixel 2 is modulated only by the gate electrode TG2. A potential gradient can be provided in the separation section 111.

### Operation of Transfer Transistor 101 in Seventh Embodiment

An operation related to readout of charges from the PD 51 of the pixel 2 having the transfer transistor 101 will be described with reference to a timing chart of Fig. 26 and a diagram for explaining a change in the sensor potential at the time of accumulation and at the time of readout illustrated in Fig. 29. Here, as an example of a driving example, a case where driving similar to that of the pixel 2 according to the sixth embodiment is performed is taken as an example, and description will be continued with reference to the timing chart illustrated in Fig. 26 as appropriate.

Note that the transfer transistor 101-1 and the transfer transistor 101-2 are driven in the same manner, and therefore, the following description will be continued by taking the transfer transistor 101-1 as an example. Further, since the transfer transistor 101-3 and the transfer transistor 101-4 are driven in the same manner, the following description will be continued by taking the transfer transistor 101-3 as an example.

The numerical values illustrated in Figs. 26 and 29 are specific numerical values for the sake of description, but are examples and are not limited.

At the time T11 (Fig. 26), the PD 51 accumulates charge. When the charge is accumulated in the PD 51, both the transfer transistor 101-1 and the transfer transistor 101-3 are turned off. When the transfer transistor 101-1 is in an off state, for example, the voltage of -1.2 V is applied. When the transfer transistor 101-3 is in the off state, for example, the voltage of 0 V is applied.

At the time T12 (Fig. 26), the transfer signal TG1 is supplied to the transfer transistor 101-1, and the transfer transistor 101-1 is turned on. An on state of the transfer transistor 101-1 is, for example, a state in which the voltage of 2.8 V is applied. At the time T12, the first transfer signal TG2 is supplied to the transfer transistor 101-3, and the transfer transistor 101-3 is set to a first on state. The first on state of the transfer transistor 101-3 is, for example, a state in which the voltage of 2.8 V is applied.

The time T12 is a time at which the transfer of the charge accumulated in the PD 51 to the FD 54 is started. Reference will be made to a potential diagram at the time T12 in Fig. 29. The region of the separation section 111 is divided into a region (referred to as a separation section 111-1) that receives modulation from the pair of the transfer transistor 101-1 and the transfer transistor 101-2 (TG1 in Fig. 29), a region (referred to as a separation section 111-2) that receives modulation from the pair of two gate electrodes TG of the pair of the transfer transistor 101-1 and the transfer transistor 101-2 (TG1 in Fig. 29), and the pair of the transfer transistor 101-3 and the transfer transistor 101-4 (TG2 in Fig. 29).

At the time T12, the potential of the separation section 111-1 and the potential of the separation section 111-2 both sink deeply, and the potential of the separation section 111-2 sinks more deeply than the potential of the separation section 111-1. As a result, the barrier of the separation section 111 can be made lower, and the transfer of the charge from the PD 51 to the FD 54 can be more reliably performed.

Since a part of the transfer transistors 101-3 and 101-4 (TG2 in Fig. 29) is provided to a position where the region where the PD 51 is provided can be modulated, a part of the PD 51 is also modulated by the transfer transistors 101-3 and 101-4. Therefore, as illustrated at the time T12 in Fig. 29, the potential of a part of the region of the PD 51 (region on the side close to the FD 54) is lowered. The potential of the PD 51 on the FD 54 side is lowered, and thus a gradient can be created, a situation is achieved in which the transfer from the PD 51 to the FD 54 is easier, and the transfer of the charge from the PD 51 to the FD 54 can be more reliably performed.

Returning to the description with reference to Fig. 26, at the time T13 when the transfer (readout) of the charge from the PD 51 to the FD 54 is performed, the transfer transistor 101-3 is turned off. When the transfer transistor 101-3 is in the off state, for example, the voltage of 0 V is applied. At the time T13, the transfer transistor 101-1 is maintained in the on state.

Reference will now be made to a potential diagram at the time T13 in Fig. 29. In the region of the separation section 111-1, the magnitude of the modulation from the pair of the transfer transistor 101-1 and the transfer transistor 101-2 (TG1 in Fig. 29) does not change, and thus a potential is maintained in the same state as the state at the time T12. In the region of the separation section 111-2, the modulation from the pair of the transfer transistor 101-3 and the transfer transistor 101-4 (TG2 in Fig. 27) is reduced, and as a result, the potential is higher than that in the state at the time T12.

The potential of the separation section 111-2 that receives modulation from the gate electrode TG2 rises, and thus the potential of the separation section 111-2 becomes higher than the potential of the separation section 111-1. The charge transferred to the separation section 111-2 at the time T12 is transferred from the separation section 111-2 to the separation section 111-1 (FD 54) at the time T13.

Since the region of the PD 51 on the FD 54 side is modulated by the transfer transistors 101-3 and 101-4 (TG2 in Fig. 29), and the modulated state changes from the first on state (2.8 V state) to the off state (0 V state), the potential is higher than that in the state at the time T12. In the state of the time T13, the potential of the separation section 111-1 is lower than the potential of the modulated region of the PD 51, and thus the charge remaining in the PD 51 is transferred to the separation section 111-1. Therefore, a situation in which all the charge remaining in the PD 51 can be transferred to the separation section 111-1 (FD 54) side can be created, and the transfer of the charge from the PD 51 to the FD 54 can be more reliably performed.

Returning to the description with reference to Fig. 26, at the time T14 before the transfer (readout) of the charge from the PD 51 to the FD 54 is ended, the transfer transistor 101-1 is turned off, and the voltage is set to -1.2 V. At the time T14, the transfer transistor 101-3 is set to a second on state. When the transfer transistor 101-3 is in the second on state, for example, a voltage of -1.2 V is applied.

Reference will be made to a potential diagram at the time T14 in Fig. 29. Since the direction of modulation from the pair of the transfer transistor 101-1 and the transfer transistor 101-2 (TG1 in Fig. 29) changes, as a result, the potential of the separation section 111-1 rises from the state at the time T13, and becomes a potential that sufficiently functions as a barrier that prevents the charge from flowing from the PD 51 to the FD 54.

In the separation section 111-2, the direction of modulation from the pair of the transfer transistor 101-1 and the transfer transistor 101-2 (TG1 in Fig. 29) changes, and the direction of modulation from the pair of the transfer transistor 101-3 and the transfer transistor 101-4 (TG2 in Fig. 29) also changes, and as a result, the potential rises from the state at the time T13, and becomes a potential that sufficiently functions as a barrier that prevents the charge from flowing from the PD 51 to the FD 54.

When the potential of the separation section 111-1 rises, the charge in the separation section 111-1 moves toward the FD 54, and thus the transfer of the charge from the PD 51 to the FD 54 can be more reliably performed.

Since the region of the PD 51 on the FD 54 side is modulated by the transfer transistors 101-3 and 101-4 (TG2 in Fig. 29) and the modulated state changes from the off state (0 V state) to the second on state (-1.2 V state), the potential is higher than that in the state at the time T13. Since the state at the time T14 can increase the potential of the modulated region of the PD 51, in other words, the potential on the side close to the FD 54, it is possible to suppress the reverse flow or pumping of the charge from the FD 54 to the PD 51. The transfer of the charge from the PD 51 to the FD 54 can be more reliably performed.

Returning to the description with reference to Fig. 26, at the time T15 when the transfer (readout) of the charge from the PD 51 to the FD 54 is ended, the transfer transistor 101-1 is maintained in the off state, and the transfer transistor 101-3 is switched to the off state (set to 0 V). This state is the same as the state at the time T11.

In the pixel 2 according to the seventh embodiment, as in the pixel 2 according to the sixth embodiment, charge transfer from the PD 51 to the FD 54 can be performed more reliably, and it is possible to prevent the charge from returning to the PD 51.

### Eighth Embodiment

Fig. 30 is a diagram depicting a planar configuration example of the pixel 2 according to an (8-1)-th embodiment. The same parts as those of the pixel 2 (Fig. 24) according to the sixth embodiment are denoted by the same reference signs, and description thereof will be omitted as appropriate.

The pixel 2 depicted in Fig. 30 is different from the pixel 2 according to the sixth embodiment in that the gate electrode TG of the transfer transistor 101 is disposed in an L-shape at four corners of the pixel 2, and other points are the same. The FD 54 is disposed at the center of the pixel 2, and the gate electrodes TG of the transfer transistors 101 are arranged so as to surround the FD 54.

The gate electrode TG1 of the transfer transistor 101-1 is provided in the L-shape at the upper left corner in the figure. The gate electrode TG1 of the transfer transistor 101-2 is provided in the L-shape at the lower right corner in the figure facing the transfer transistor 101-1. The gate electrode TG2 of the transfer transistor 101-3 is provided in the L-shape at the upper right corner in the figure. The gate electrode TG2 of the transfer transistor 101-4 is provided in the L-shape at the lower left corner in the figure facing the transfer transistor 101-3.

The gate electrodes TG of the transfer transistors 101 may be arranged and shaped in this manner, and the above-described driving is performed, so that the transfer of charge from the PD 51 to the FD 54 can be more reliably performed.

Fig. 31 is a diagram depicting a planar configuration example of the pixel 2 according to an (8-2)-th embodiment. The pixel 2 depicted in Fig. 31 is similar to the pixel 2 depicted in Fig. 30 in that the gate electrodes TG of the transfer transistors 101 are arranged in an L-shape at the corners of the pixel 2, but the shape and arrangement position of the gate electrodes TG of the transfer transistors 101 are different, and the arrangement position of the FD 54 is different. The FD 54 is disposed along the inter-pixel separation section 52 of one side (the right side in Fig. 31) of the four sides of the pixel 2, and is disposed such that the central portion of the side and the central portion of the FD 54 substantially coincide with each other.

The gate electrode TG1 of the transfer transistor 101-1 is provided in the L-shape at the upper right corner in the figure. The gate electrode TG1 of the transfer transistor 101-2 is provided in the L-shape at the lower right corner in the figure. The two sides of the L-shaped gate electrode TG1 may be formed to have the same length, or the side that is disposed at an angle of 90 degrees may be formed to be longer than the side that is disposed on the same side as the FD 54.

The gate electrode TG2 of the transfer transistor 101-3 is provided in the L-shape at the upper left corner in the figure. The gate electrode TG2 of the transfer transistor 101-4 is provided in the L-shape at the lower left corner in the figure. The two sides of the L-shaped gate electrode TG2 may be formed to have the same length, or the side that is disposed at an angle of 90 degrees may be formed longer than the side that is disposed on the side facing the FD 54.

In the case of such an arrangement and shape of the gate electrodes TG of the transfer transistors 101, as indicated by the arrow in Fig. 31, a path through which the charge is transferred from the gate electrodes TG2 to the FD 54 side can be created. The gate electrodes TG of the transfer transistors 101 may be arranged and shaped in this manner, and the above-described driving is performed, so that the transfer of the charge from the PD 51 to the FD 54 can be more reliably performed.

Fig. 32 is a diagram depicting a planar configuration example of the pixel 2 according to an (8-3)-th embodiment. The pixel 2 depicted in Fig. 32 is different from the pixel 2 depicted in Fig. 31 in that the gate electrodes TG1 of the transfer transistors 101-1 and 101-2 are arranged in a linear shape on the sides of the inter-pixel separation section 52 of the pixel 2.

The gate electrode TG1 of the transfer transistor 101-1 is provided in the linear shape on the upper side in the figure. The gate electrode TG1 of the transfer transistor 101-2 is provided in the linear shape on the lower side in the figure facing the transfer transistor 101-1. By forming the gate electrode TG1 in the linear shape, the FD 54 can be formed large.

The gate electrode TG2 of the transfer transistor 101-3 and the gate electrode TG2 of the transfer transistor 101-4 are provided in an L-shape at the upper left corner and the lower left corner, respectively, as in the pixel 2 (31) in the (8-2)-th embodiment.

In the case of such an arrangement and shape of the gate electrodes TG of the transfer transistors 101, as indicated by the arrow in Fig. 32, a path through which the charge is transferred from the gate electrodes TG2 side to the FD 54 side can be created. The gate electrodes TG of the transfer transistors 101 may be arranged and shaped in this manner, and the above-described driving is performed, so that the transfer of the charge from the PD 51 to the FD 54 can be more reliably performed.

### Ninth Embodiment

Fig. 33 is a diagram depicting a planar configuration example of the pixel 2 according to a (9-1)-th embodiment. The same parts as those of the pixel 2 (Fig. 24) according to the sixth embodiment are denoted by the same reference signs, and description thereof will be omitted as appropriate.

In the pixel 2 described with reference to Figs. 24 to 32, the case where the transfer transistor 101 has two pairs of gate electrodes TG has been described as an example, but two or more pairs of gate electrodes TG may be provided. The pixel 2 depicted in Fig. 33 indicates an example having three pairs of gate electrodes TG. The FD 54 is disposed at the center of the pixel 2, and the gate electrodes TG of the three pairs of transfer transistors 101 are arranged so as to surround the FD 54.

The gate electrode TG1 of the transfer transistor 101-1 is provided in the central portion of the upper side in the figure. The gate electrode TG1 of the transfer transistor 101-2 is provided in the central portion of the lower side in the figure facing the transfer transistor 101-1.

The gate electrode TG2 of the transfer transistor 101-3 is provided at the upper right corner in the figure. The gate electrode TG2 of the transfer transistor 101-4 is provided at the lower left corner in the figure facing the transfer transistor 101-4.

A gate electrode TG3 of a transfer transistor 101-5 is provided at the upper left corner in the figure. The gate electrode TG3 of the transfer transistor 101-5 is provided at the lower right corner in the figure facing the transfer transistor 101-5.

The gate electrodes TG1, TG2, and TG3 are all formed in a linear shape.

Although not illustrated, the depth of the gate electrode TG1, the depth of the gate electrode TG2, and the depth of the gate electrode TG3 increase in this order. That is, the gate electrodes TG are formed to have a size satisfying the relationship of the depth of the gate electrode TG1 < the depth of the gate electrode TG2 < the depth of the gate electrode TG3.

The depth of the gate electrode TG3 may be, for example, substantially the same as the depth of the gate electrode TG2 of the pixel 2 in the sixth embodiment (Fig. 25). Further, the depth of the gate electrode TG2 is shallower than the depth of the gate electrode TG2 (Fig. 25) of the pixel 2 in the sixth embodiment, and the depth of the gate electrode TG1 is shallower than the depth of the gate electrode TG1 (Fig. 25) of the pixel 2 in the sixth embodiment.

By increasing the number of transfer transistors 101, modulation with respect to the separation section 111 and the PD 51 can be more finely controlled. For example, it is possible to control a voltage applied to the transfer transistor 101 and to set and control the timing of applying the voltage more finely, and it is possible to perform the control of the transfer of charge from the PD 51 to the FD 54 with finer control. The arrangement, shape, and number of the gate electrodes TG of the transfer transistors 101 may be adopted in this manner, and by performing the driving as described above, it is possible to more reliably transfer the charge from the PD 51 to the FD 54.

Fig. 34 is a diagram depicting a planar configuration example of the pixel 2 according to a (9-2)-th embodiment. The pixel 2 depicted in Fig. 34 is different from the pixel 2 depicted in Fig. 33 in that the gate electrodes TG2 and TG3 of the transfer transistors 101 are arranged in an L-shape at the corners of the pixel 2.

The gate electrode TG1 of the transfer transistor 101-1 is provided in the central portion of the upper side in the figure. The gate electrode TG1 of the transfer transistor 101-2 is provided in the central portion of the lower side in the figure facing the transfer transistor 101-1.

The gate electrode TG2 of the transfer transistor 101-3 is provided in an L-shape at the upper right corner in the figure. At the lower left corner in the figure facing the transfer transistor 101-4, the gate electrode TG2 of the transfer transistor 101-4 is provided in an L-shape.

The gate electrode TG3 of the transfer transistor 101-5 is provided in an L-shape at the upper left corner in the figure. The gate electrode TG3 of a transfer transistor 101-6 is provided in an L-shape at the lower right corner in the figure facing the transfer transistor 101-5.

The arrangement, shape, and number of the gate electrodes TG of the transfer transistors 101 may be adopted in this manner, and by performing the driving as described above, it is possible to more reliably transfer the charge from the PD 51 to the FD 54.

Fig. 35 is a diagram depicting a planar configuration example of the pixel 2 according to a (9-3)-th embodiment. The pixel 2 depicted in Fig. 35 is substantially the same as the pixel 2 depicted in Fig. 34 in the shape of the gate electrodes TG, but is different from the pixel 2 depicted in Fig. 34 in the arrangement positions of the gate electrodes TG and the position of the FD 54.

The gate electrode TG1 of the transfer transistor 101-1 is provided in an L-shape at the upper right corner in the figure. The gate electrode TG1 of the transfer transistor 101-2 is provided in an L-shape at the lower right corner in the figure. The FD 54 is disposed between the gate electrode TG1 of the transfer transistor 101-1 and the gate electrode TG1 of the transfer transistor 101-2, and is disposed along the inter-pixel separation section 52.

The gate electrode TG2 of the transfer transistor 101-3 is provided on the upper side in the figure. The gate electrode TG2 of the transfer transistor 101-4 is provided on the lower side in the figure facing the transfer transistor 101-4.

The gate electrode TG3 of the transfer transistor 101-5 is provided in an L-shape at the upper left corner in the figure. The gate electrode TG3 of the transfer transistor 101-6 is provided in an L-shape at the lower right corner in the figure.

The arrangement, shape, and number of the gate electrodes TG of the transfer transistors 101 may be adopted in this manner, and by performing the driving as described above, it is possible to more reliably transfer the charge from the PD 51 to the FD 54.

Fig. 36 is a diagram depicting a planar configuration example of the pixel 2 according to a (9-4)-th embodiment. In the pixel 2 illustrated in Fig. 36, the FD 54 is disposed at a corner in the pixel 2, and three pairs of gate electrodes TG are arranged such that the charge from the PD 51 is easily transferred to the FD 54.

The FD 54 is provided in a triangular shape at the upper right corner in the figure. The transfer transistor 101-1 and the transfer transistor 101-2 are arranged near the FD 54. The gate electrode TG1 of the transfer transistor 101-1 is provided along the inter-pixel separation sections 52 on the upper side in the figure. The gate electrode TG1 of the transfer transistor 101-2 is provided along the inter-pixel separation section 52 on the left side in the figure that intersects the side on which the transfer transistor 101-1 is provided at an angle of 90 degrees.

The gate electrode TG2 of the transfer transistor 101-3 is provided in a linear shape at the upper left corner in the figure. At the lower right corner in the figure facing the transfer transistor 101-3, the gate electrode TG2 of the transfer transistor 101-4 is provided in a linear shape. Note that, although the case where the gate electrodes TG2 are provided in a linear shape is described here as an example, the gate electrodes TG2 may be provided in an L-shape at the corners of the pixel 2.

The gate electrode TG3 of the transfer transistor 101-5 is provided along the inter-pixel separation section 52 on the left side in the figure. The gate electrode TG3 of the transfer transistor 101-6 is provided along the inter-pixel separation sections 52 on the lower side in the figure that intersects the side on which the transfer transistor 101-5 is provided at an angle of 90 degrees.

The arrangement, shape, and number of the gate electrodes TG of the transfer transistors 101 may be adopted in this manner, and by performing the driving as described above, it is possible to more reliably transfer the charge from the PD 51 to the FD 54.

### Tenth Embodiment

Fig. 37 is a diagram depicting a planar configuration example of the pixel 2 according to a (10-1)-th embodiment. The same parts as those of the pixel 2 (Fig. 24) according to the sixth embodiment are denoted by the same reference signs, and description thereof will be omitted as appropriate.

The FD 54 of the pixel 2 in the (10-1)-th embodiment depicted in Fig. 37 is provided in a triangular shape at the upper right corner in the figure in the pixel 2, similarly to the FD 54 of the pixel 2 in the (9-4)-th embodiment depicted in Fig. 36. In this manner, when the FD 54 is provided at the corner of the pixel 2, the gate electrodes TG as a pair are arranged at positions having an angle of 90 degrees.

In other words, although the pixel 2 according to the (9-4)-th embodiment depicted in Fig. 36 has been described as including three pairs of gate electrodes TG, when the two pairs of gate electrodes TG are provided, such a configuration of the pixel 2 according to the (10-1)-th embodiment depicted in Fig. 37 may be adopted.

The gate electrode TG1 of the transfer transistor 101-1 is provided along the inter-pixel separation sections 52 on the upper side in the figure. The gate electrode TG1 of the transfer transistor 101-2 is provided along the inter-pixel separation section 52 on the left side in the figure that intersects the side on which the transfer transistor 101-1 is provided at an angle of 90 degrees.

The gate electrode TG2 of the transfer transistor 101-3 is provided along the inter-pixel separation section 52 on the right side in the figure. The gate electrode TG2 of the transfer transistor 101-4 is provided along the inter-pixel separation section 52 on the lower side in the figure that intersects the side on which the transfer transistor 101-3 is provided at an angle of 90 degrees.

The arrangement, shape, and number of the gate electrodes TG of the transfer transistors 101 may be adopted in this manner, and by performing the driving as described above, it is possible to more reliably transfer the charges from the PD 51 to the FD 54.

Fig. 38 is a diagram depicting a planar configuration example of the pixel 2 according to a (10-2)-th embodiment. The pixel 2 according to the (10-2)-th embodiment is different in shape from the gate electrode TG of the pixel 2 in the (10-1)-th embodiment depicted in Fig. 37, and the other points are the same.

The gate electrode TG1 of the transfer transistor 101-1 is formed in a triangular shape, and one of the three sides thereof is provided along the inter-pixel separation section 52 on the upper side in the figure. The gate electrode TG1 of the transfer transistor 101-2 is provided in a triangular shape along the inter-pixel separation section 52 on the left side in the figure that intersects the side on which the transfer transistor 101-1 is provided at an angle of 90 degrees.

The gate electrode TG2 of the transfer transistor 101-3 is formed in a triangular shape, and one of the three sides thereof is provided along the inter-pixel separation section 52 on the right side in the figure. The gate electrode TG2 of the transfer transistor 101-4 is provided in a triangular shape along the inter-pixel separation section 52 on the lower side in the figure that intersects the side on which the transfer transistor 101-3 is provided at an angle of 90 degrees.

The arrangement, shape, and number of the gate electrodes TG of the transfer transistors 101 may be adopted in this manner, and by performing the driving as described above, it is possible to more reliably transfer the charge from the PD 51 to the FD 54.

Fig. 39 is a cross-sectional view of the pixel 2 when the direction in which the gate electrodes TG1 and TG2 are arranged is viewed in the dotted line (the dotted line drawn diagonally from the upper right to the lower left in the figure) in the pixel 2 illustrated in Figs. 37 and 38. The gate electrode TG2 of the transfer transistor 101-3 is provided to a region overlapping a part of the PD 51. The gate electrode TG1 of the transfer transistor 101-1 is provided on the right side of the gate electrode TG2 of the transfer transistor 101-3 in the figure. Further, the FD 54 is provided on the right side of the gate electrode TG1 of the transfer transistor 101-1 in the figure.

Charge accumulated in the PD 51 is transferred to the FD 54 through a region modulated by the gate electrode TG2 and a region modulated by the gate electrode TG1, as indicated by the white arrow in the figure. Such a path for charge transfer can be created by controlling voltages applied to the gate electrodes TG2 and TG1 independently of each other. Therefore, in the pixel 2 according to the tenth embodiment, the transfer of the charge from the PD 51 to the FD 54 can be performed more reliably as in the other embodiments.

When the pixel 2 according to the sixth to tenth embodiments is miniaturized, the distance between the gate electrodes TG as a pair to each other becomes closer, and thus, even the central portion of the separation section 111 can be efficiently modulated, so that the pixel 2 can achieve a configuration in which the charge transfer from the PD 51 to the FD 54 can be more reliably performed.

Any two or more of the first to tenth embodiments can be implemented in combination.

### Application Example of Electronic Apparatus

The present technology is applicable to general electronic apparatuses that use an imaging element in an image capturing section (photoelectric conversion section), such as an imaging device such as a digital still camera or a video camera, a portable terminal device having an imaging function, or a copying machine that uses an imaging element in an image readout section. The imaging element may be formed as one chip, or may be formed in a module state having an imaging function in which an imaging section and a signal processing unit or an optical system are collectively packaged.

Fig. 40 is a block diagram depicting a configuration example of an imaging device as an electronic apparatus to which the present technology is applied.

An imaging element 1000 in Fig. 40 includes an optical section 1001 including a lens group and the like, an imaging element (imaging device) 1002, and a digital signal processor (DSP) circuit 1003 that is a camera signal processing circuit. The imaging element 1000 also includes a frame memory 1004, a display section 1005, a recording section 1006, an operation section 1007, and a power supply section 1008. The DSP circuit 1003, the frame memory 1004, the display section 1005, the recording section 1006, the operation section 1007, and the power supply section 1008 are connected to each other via a bus line 1009.

The optical section 1001 captures incident light (image light) from a subject and forms an image on an imaging surface of the imaging element 1002. The imaging element 1002 converts the amount of incident light imaged on the imaging surface by the optical section 1001 into an electric signal in units of pixels and outputs the electric signal as a pixel signal.

The display section 1005 is configured by a thin display such as a liquid crystal display (LCD) or an organic electro-luminescence (EL) display, for example, and displays a moving image or a still image imaged by the imaging element 1002. The recording section 1006 records the moving image or the still image imaged by the imaging element 1002 in a recording medium such as a hard disk or a semiconductor memory.

The operation section 1007 issues operation commands for various functions of the imaging element 1000 under the operation of a user. The power supply section 1008 appropriately supplies various power supplies serving as operation power supplies of the DSP circuit 1003, the frame memory 1004, the display section 1005, the recording section 1006, and the operation section 1007 to these supply targets.

The imaging device 1 according to the first to fifth embodiments can be applied to part of the imaging device depicted in Fig. 40.

### Application Example of Endoscopic Surgery System

The technology according to the present disclosure (present technology) can be applied to various products. For example, the technology according to the present disclosure may be applied to an endoscopic surgery system.

Fig. 41 is a view depicting an example of a schematic configuration of an endoscopic surgery system to which the technology according to an embodiment of the present disclosure (present technology) can be applied.

In Fig. 41, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy treatment tool 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body lumen of the patient 11132, and a camera head 11102 connected to a proximal end of the lens barrel 11101. In the example depicted, the endoscope 11100 is depicted which includes as a hard mirror having the lens barrel 11101 of the hard type. However, the endoscope 11100 may otherwise be included as a soft mirror having the lens barrel 11101 of the soft type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body lumen of the patient 11132 through the objective lens. It is to be noted that the endoscope 11100 may be a direct view mirror or may be a perspective view mirror or a side view mirror.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy treatment tool 11112 for cautery or incision of a tissue, sealing of a blood vessel or the like. A pneumoperitoneum apparatus 11206 feeds gas into a body lumen of the patient 11132 through the pneumoperitoneum tube 11111 to inflate the body lumen in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203.

Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrowband light and/or excitation light suitable for special light observation as described above.

Fig. 42 is a block diagram depicting an example of a functional configuration of the camera head 11102 and the CCU 11201 depicted in Fig. 41.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy treatment tool 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

### Application Example of Mobile Body

The technology according to the present disclosure (present technology) can be applied to various products. For example, the technology according to the present disclosure may be implemented as a device mounted on any type of mobile body such as a vehicle, an electric vehicle, a hybrid electric vehicle, a motorcycle, a bicycle, a personal mobility, an airplane, a drone, a ship, and a robot.

Fig. 43 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in Fig. 43, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12030 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of Fig. 43, an audio speaker 12061, a display section 12062, and an instrument panel 12063 are illustrated as the output device. The display section 12062 may, for example, include at least one of an on-board display and a head-up display.

Fig. 44 is a diagram depicting an example of the installation position of the imaging section 12031.

In Fig. 44, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, Fig. 44 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

In the present specification, the system represents a device as a whole constituted by a plurality of devices.

Note that the effects described in the present specification are merely examples and are not limited, and other effects may be provided.

Note that the embodiments of the present technology are not limited to the embodiments described above, and can be modified within a range that does not depart from the gist of the present technology.

Note that the present technology can also adopt configurations such as the following.
(1) A light detection device including:
   a photoelectric conversion section formed in a semiconductor substrate and configured to convert light into charge;
   an accumulation section configured to temporarily accumulate the charge;
   a transfer section configured to perform transfer of the charge to the accumulation section;
   an assist section configured to assist at least one or both of the transfer by the transfer section and an increase in a saturation charge amount;
   a first electrode included in the transfer section and located on a front surface of the semiconductor substrate; and
   a second electrode included in the assist section and located in the semiconductor substrate.
(2) The light detection device according to (1) further including an inter-pixel separation section separating pixels, in which
   the second electrode is provided on a side surface of the inter-pixel separation section.
(3) The light detection device according to (2), in which
   the second electrode is provided on a side surface of the inter-pixel separation section from a first position to a second position in a depth direction of the semiconductor substrate with the front surface as a reference.
(4) The light detection device according to (3), in which
   the first position is a position of the front surface.
(5) The light detection device according to (3), in which
   the first position is a position deeper than the front surface by a predetermined depth.
(6) The light detection device according to any one of (2) to (5), in which
   the second electrode provided on a first side of the inter-pixel separation section surrounding the photoelectric conversion section and the second electrode provided on a second side facing the first side are provided at the same depth.
(7) The light detection device according to any one of (2) to (5), in which
   the second electrode provided on a first side of the inter-pixel separation section surrounding the photoelectric conversion section and the second electrode provided on a second side intersecting the first side at a right angle are provided at the same depth.
(8) The light detection device according to any one of (2) to (7), in which
   a first position of the second electrode provided on a first side of the inter-pixel separation section surrounding the photoelectric conversion section is different from a first position of the second electrode provided on a second side of the inter-pixel separation section.
(9) The light detection device according to any one of (2) to (7), in which
   a second position of the second electrode provided on a first side of the inter-pixel separation section is different from a second position of the second electrode provided on a second side of the inter-pixel separation section.
(10) The light detection device according to any one of (2) to (7), in which
   a first position of the second electrode provided on a first side of the inter-pixel separation section surrounding the photoelectric conversion section is the same as a first position of the second electrode provided on a second side of the inter-pixel separation section, and
   a second position of the second electrode provided on the first side of the inter-pixel separation section is different from a second position of the second electrode provided on the second side of the inter-pixel separation section.
(11) The light detection device according to any one of (2) to (10), in which
   the second electrode is in the inter-pixel separation section.
(12) The light detection device according to any one of (1) to (11), in which
   the first electrode and the second electrode are connected to different power supply voltages.
(13) The light detection device according to any one of (1) to (12), in which
   the assist section assists the transfer by the transfer section.
(14) The light detection device according to any one of (1) to (12), in which
   the assist section assists an increase in the saturation charge amount.
(15) The light detection device according to any one of (1) to (12), in which
   the assist section assists the transfer by the transfer section and an increase in the saturation charge amount.
(16) The light detection device according to any one of (1) to (15), in which
   after a first voltage is applied to the transfer section, a second voltage is applied to the assist section.
(17) The light detection device according to (16), in which
   the first voltage is a positive voltage, and the second voltage is a negative voltage.
(18) The light detection device according to (16), in which
   the assist section includes two or more assist sections, and
   after the second voltage is applied to a first assist section, the second voltage is applied to a second assist section.
(19) The light detection device according to (1), further including the assist section to which a fixed voltage is applied.
(20) An electronic apparatus including:
   a light detection device including:
   a photoelectric conversion section formed in a semiconductor substrate and configured to convert light into charge;
   an accumulation section configured to temporarily accumulate the charge;
   a transfer section configured to perform transfer of the charge to the accumulation section;
   an assist section configured to assist at least one or both of the transfer by the transfer section and an increase in a saturation charge amount;
   a first electrode included in the transfer section on a front surface of the semiconductor substrate; and
   a second electrode included in the assist section in the semiconductor substrate; and
   a processing unit configured to process a signal from the light detection device.
(21) A light detection device including:
   a photoelectric conversion section formed in a semiconductor substrate and configured to convert light into charge;
   an accumulation section configured to temporarily accumulate the charge;
   a first transfer section configured to perform transfer of the charge to the accumulation section; and
   a second transfer section, in which
   in a depth direction of the semiconductor substrate with a front surface of the semiconductor substrate as a reference, a first electrode included in the first transfer section is provided from a first position as the reference to a second position,
   a second electrode included in the second transfer section is provided from the first position to a third position deeper than the second position,
   the first electrode includes two electrodes disposed at positions facing each other, the two electrodes forming a pair, and
   the second electrode includes two electrodes disposed at positions facing each other, the two electrodes forming a pair.
(22) The light detection device according to (21), in which
   the first transfer section and the second transfer section are controlled independently of each other.
(23) The light detection device according to (21) or (22), in which
   the second electrode is provided to a depth at which the photoelectric conversion section is provided.
(24) The light detection device according to any one of (21) to (23), further including an inter-pixel separation section separating pixels, in which
   the first electrode and the second electrode are respectively provided on side surfaces of the inter-pixel separation section.
(25) The light detection device according to (24), in which
   the first electrode provided on a first side of the inter-pixel separation section surrounding the photoelectric conversion section and the first electrode provided on a second side facing the first side are provided to the same depth, and
   the second electrode provided on a third side of the inter-pixel separation section surrounding the photoelectric conversion section and the second electrode provided on a fourth side facing the third side are provided to the same depth.
(26) The light detection device according to any one of (21) to (25), further including a third transfer section, in which
   a third electrode included in the third transfer section is provided from the first position to a fourth position deeper than the third position, and
   the third electrode includes two electrodes disposed at positions facing each other, the two electrodes forming a pair.
(27) The light detection device according to any one of (21) to (26), in which
   a first sidewall is provided on a part of a side surface of the first electrode, and
   a second sidewall is provided on a part of a side surface of the second electrode.
(28) The light detection device according to (27), in which
   the first sidewall is provided from the first position to a fifth position shallower than the second position, and
   the second sidewall is provided from the first position to a sixth position deeper than the fifth position and shallower than the third position.
(29) The light detection device according to any one of (21) to (28), in which
   each of the first electrode and the second electrode is provided at a portion being a corner of a pixel, and
   at least one of the first electrode and the second electrode is formed in an L shape.
(30) The light detection device according to (24), in which
   the first electrode provided on a first side of the inter-pixel separation section surrounding the photoelectric conversion section and the first electrode provided on a second side intersecting the first side at a right angle are provided at the same depth, and
   the second electrode provided on a third side of the inter-pixel separation section surrounding the photoelectric conversion section and the second electrode provided on a fourth side intersecting the third side at a right angle are provided at the same depth.
(31) The light detection device according to any one of (21) to (30), in which
   when transfer of charge from the photoelectric conversion section to the accumulation section is started, a first voltage is applied to the first transfer section, and a second voltage is applied to the second transfer section,
   the second transfer section is turned off after a predetermined time has elapsed,
   the first transfer section is turned off before the transfer is ended, and a third voltage is applied to the second transfer section, and
   after a predetermined time has elapsed, the second transfer section is turned off.
(32) An electronic apparatus including:
   a light detection device including:
   a photoelectric conversion section formed in a semiconductor substrate and configured to convert light into charge;
   an accumulation section configured to temporarily accumulate the charge;
   a first transfer section configured to perform transfer of the charge to the accumulation section; and
   a second transfer section, in which
   in a depth direction of the semiconductor substrate with a front surface of the semiconductor substrate as a reference, a first electrode included in the first transfer section is provided from a first position as the reference to a second position,
   a second electrode included in the second transfer section is provided from the first position to a third position deeper than the second position,
   the first electrode includes two electrodes disposed at positions facing each other, the two electrodes forming a pair, and
   the second electrode includes two electrodes disposed at positions facing each other, the two electrodes forming a pair, and
   a processing unit configured to process a signal from the light detection device.

### Reference Signs List

1 Imaging device, 2 Pixel, 3 Pixel array section, 4 Vertical drive circuit, 5 Column signal processing circuit, 6 Horizontal drive circuit, 7 Output circuit, 8 Control circuit, 9 Vertical signal line, 10 Pixel drive line, 11 Horizontal signal line, 13 Input/output terminal, 50 Semiconductor substrate, 52 Inter-pixel separation section, 53 Transfer transistor, 54 FD portion, 55 Reset transistor, 56 Amplification transistor, 57 Selection transistor, 61 Assist transistor, 71 Driver, 81 Wiring line

## Claims

1. A light detection device comprising:
a photoelectric conversion section formed in a semiconductor substrate and configured to convert light into charge;
an accumulation section configured to temporarily accumulate the charge;
a transfer section configured to perform transfer of the charge to the accumulation section;
an assist section configured to assist at least one or both of the transfer by the transfer section and an increase in a saturation charge amount;
a first electrode included in the transfer section and located on a front surface of the semiconductor substrate; and
a second electrode included in the assist section and located in the semiconductor substrate.

2. The light detection device according to claim 1, further comprising an inter-pixel separation section separating pixels, wherein
the second electrode is provided on a side surface of the inter-pixel separation section.

3. The light detection device according to claim 2, wherein
the second electrode is provided on a side surface of the inter-pixel separation section from a first position to a second position in a depth direction of the semiconductor substrate with the front surface as a reference.

4. The light detection device according to claim 3, wherein
the first position is a position of the front surface or a position deeper than the front surface by a predetermined depth.

5. The light detection device according to claim 2, wherein
the second electrode provided on a first side of the inter-pixel separation section surrounding the photoelectric conversion section and the second electrode provided on a second side facing the first side are provided at the same depth.

6. The light detection device according to claim 2, wherein
the second electrode provided on a first side of the inter-pixel separation section surrounding the photoelectric conversion section and the second electrode provided on a second side intersecting the first side at a right angle are provided at the same depth.

7. The light detection device according to claim 2, wherein
a first position of the second electrode provided on a first side of the inter-pixel separation section surrounding the photoelectric conversion section is different from a first position of the second electrode provided on a second side of the inter-pixel separation section.

8. The light detection device according to claim 2, wherein
a second position of the second electrode provided on a first side of the inter-pixel separation section is different from a second position of the second electrode provided on a second side of the inter-pixel separation section.

9. The light detection device according to claim 2, wherein
a first position of the second electrode provided on a first side of the inter-pixel separation section surrounding the photoelectric conversion section is the same as a first position of the second electrode provided on a second side of the inter-pixel separation section, and
a second position of the second electrode provided on the first side of the inter-pixel separation section is different from a second position of the second electrode provided on the second side of the inter-pixel separation section.

10. The light detection device according to claim 2, wherein
the second electrode is in the inter-pixel separation section.

11. The light detection device according to claim 1, wherein
the first electrode and the second electrode are connected to different power supply voltages.

12. The light detection device according to claim 1, further comprising the assist section to which a fixed voltage is applied.

13. A light detection device comprising:
a photoelectric conversion section formed in a semiconductor substrate and configured to convert light into charge;
an accumulation section configured to temporarily accumulate the charge;
a first transfer section configured to perform transfer of the charge to the accumulation section; and
a second transfer section, wherein
in a depth direction of the semiconductor substrate with a front surface of the semiconductor substrate as a reference, a first electrode included in the first transfer section is provided from a first position as the reference to a second position,
a second electrode included in the second transfer section is provided from the first position to a third position deeper than the second position,
the first electrode includes two electrodes disposed at positions facing each other, the two electrodes forming a pair, and
the second electrode includes two electrodes disposed at positions facing each other, the two electrodes forming a pair.

14. The light detection device according to claim 13, wherein
the first transfer section and the second transfer section are controlled independently of each other.

15. The light detection device according to claim 13, wherein
the second electrode is provided to a depth at which the photoelectric conversion section is provided.

16. The light detection device according to claim 13, further comprising an inter-pixel separation section separating pixels, wherein
the first electrode and the second electrode are respectively provided on side surfaces of the inter-pixel separation section.

17. The light detection device according to claim 13, wherein
a first sidewall is provided on a part of a side surface of the first electrode, and
a second sidewall is provided on a part of a side surface of the second electrode.

18. The light detection device according to claim 17, wherein
the first sidewall is provided from the first position to a fifth position shallower than the second position, and
the second sidewall is provided from the first position to a sixth position deeper than the fifth position and shallower than the third position.

19. The light detection device according to claim 13, wherein
each of the first electrode and the second electrode is provided at a portion being a corner of a pixel, and
at least one of the first electrode and the second electrode is formed in an L shape.

20. The light detection device according to claim 16, wherein
the first electrode provided on a first side of the inter-pixel separation section surrounding the photoelectric conversion section and the first electrode provided on a second side intersecting the first side at a right angle are provided at the same depth, and
the second electrode provided on a third side of the inter-pixel separation section surrounding the photoelectric conversion section and the second electrode provided on a fourth side intersecting the third side at a right angle are provided at the same depth.
